(19)

**Europäisches Patentamt**
**European Patent Office**
**Office européen des brevets**

(11) **EP 4 567 805 A1**

(12) **EUROPEAN PATENT APPLICATION**

(43) Date of publication:
**11.06.2025 Bulletin 2025/24**

(21) Application number: **24180802.1**

(22) Date of filing: **07.06.2024**

(51) International Patent Classification (IPC):
**G11C 11/22** (2006.01) **G11C 7/10** (2006.01)
**G06F 7/58** (2006.01)

(52) Cooperative Patent Classification (CPC):
**G11C 7/1006; G06F 7/588; G11C 11/22;**
**G11C 11/2295;** G11C 11/2273; G11C 11/2275;
H10B 53/00; H10F 99/00

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **04.12.2023 KR 20230173074**
**04.12.2023 KR 20230173075**
**04.12.2023 KR 20230173076**
**29.02.2024 KR 20240029735**

(71) Applicant: **Research & Business Foundation**
**Sungkyunkwan**
**University**
**Gyeonggi-do 16419 (KR)**

(72) Inventors:
• **LEE, Sung Joo**
**13531 Gyeonggi-do (KR)**
• **LEE, Yoon Myung**
**13523 Gyeonggi-do (KR)**
• **KANG, Seong Kweon**
**16421 Gyeonggi-do (KR)**

• **DAS, Biswajit**
**16362 Gyeonggi-do (KR)**
• **LEE, Sang Min**
**16322 Gyeonggi-do (KR)**
• **HONG, Doo Jin**
**13601 Gyeonggi-do (KR)**
• **KIM, Jae Rok**
**16418 Gyeonggi-do (KR)**
• **CHOI, Hae Ju**
**16421 Gyeonggi-do (KR)**
• **BAEK, Sung Pyo**
**16417 Gyeonggi-do (KR)**
• **KANG, Tae Ho**
**07018 Seoul (KR)**
• **JANG, Cheol Hwa**
**16419 Gyeonggi-do (KR)**
• **NOH, Jong Min**
**16418 Gyeonggi-do (KR)**
• **LEE, Na Yeong**
**16417 Gyeonggi-do (KR)**

(74) Representative: **Dr. Gassner & Partner mbB**
**Wetterkreuz 3**
**91058 Erlangen (DE)**

(54) **FERROELECTRIC STRUCTURE AND MANUFACTURING METHOD THEREOF, TRUE RANDOM NUMBER GENERATOR USING THE SAME, SOLAR CELL USING THE SAME, AND NON-VOLATILE RF SWITCH USING THE SAME**

(57) Provided is a ferroelectric structure. The ferroelectric structure includes: a substrate; a lower electrode disposed on the substrate; a ferroelectric layer disposed on the lower electrode and including a two-dimensional ferroelectric material; and an upper electrode disposed on the ferroelectric layer, in which a current value of random intensity is obtained for the same voltage being applied.

【Fig. 1】

```
        Start
          │
  Preparing substrate          ─S110
          │
  Forming lower electrode on substrate    ─S120
          │
  Forming ferroelectric including two-dimensional
  ferroelectric material on lower electrode   ─S130
          │
  Forming upper electrode on ferroelectric layer   ─S140
          │
         End
```

**EP 4 567 805 A1**

**Description**

BACKGROUND OF THE INVENTION

1. Field of the Invention

The present application relates to a ferroelectric structure and a method for manufacturing the same, and more specifically, to a ferroelectric structure having a structure in which a ferroelectric layer is disposed between an upper electrode and a lower electrode, and a method for manufacturing the same.

The ferroelectric structure and the method for manufacturing the same according to an embodiment of the present application may be applied to a true random number generator, a solar cell, and a non-volatile RF switch.

2. Description of the Related Art

Due to the rapid growth of the Internet of Things (IoT), vast amounts of data are generated and exchanged. As a result, there is a growing concern about security of data, especially confidentiality, integrity, and authentication. However, due to the spread of IoT devices, there is no integrated security standard, and these IoT devices are vulnerable to attacks, and thus a serious security problem is raised.

Encryption keys have traditionally been used to protect data, but are increasingly vulnerable to machine learning (ML) and physical attacks. In order to solve this problem, a random number generator (RNG) has attracted attention.

More specifically, as for a random number generator, a CMOS device-based pseudo random number generator (PRNG) model is currently in use. However, the existing CMOS-based random number generator model has a limitation in that it is a system implemented with a complex circuit structure and a complex algorithm for imitating a random number rather than a perfect random number. This has limitations in direct application to the IoT industry, in which vast amounts of data are generated, and has a fatal problem of hacking passwords as long as a complex algorithm structure may be interpreted.

As described above, unlike the software-based pseudo random number generator (PRNG) that extends an initial seed into a bit sequence using a mathematical algorithm, a true random number generator (TRNG) generates statistically independent bits by utilizing physical properties of random and unpredictable hardware systems. Therefore, the true random number generator needs in-depth research as a major candidate that may be applied to data encryption technology that currently occurs on a vast scale.

For example, 'Z. Wei; Y. Katoh; S. Ogasahara; Y. Yoshimoto; K. Kawai; Y. Ikeda; K. Eriguchi; K. Ohmori; S. Yoneda, True random number generator using current difference based on a fractional stochastic model in 40-nm embedded ReR_AM, 2016 IEEE International Electron Devices Meeting (IEDM)' discloses a true random number using tantalum oxide ($Ta_2O_5$), which is a resistance variable material.

For another example, Bo Liu; Jing Ma; Han Hsiang Tai; Dharmendra Verma; Mamina Sahoo; Ying-Feng Chang; Hanyuan Liang; Shiwei Feng; Lain-Jong Li; Tuo-Hung Hou; Chao-Sung Lai, Memristive True Random Number Generator with Intrinsic Two-Dimensional Physical Unclonable Function, ACS Appl. Electron. Mater. 2023, 5, 2, 714-720' discloses a true random number generator using aluminum oxide ($AlO_x$), which is a resistance variable material.

[Related Art Document]

[Non-Patent Documents]

Z. Wei; Y. Katoh; S. Ogasahara; Y. Yoshimoto; K. Kawai; Y. Ikeda; K. Eriguchi; K. Ohmori; S. Yoneda, True random number generator using current difference based on a fractional stochastic model in 40-nm embedded ReR_AM, 2016 IEEE International Electron Devices Meeting (IEDM)

Bo Liu; Jing Ma; Han Hsiang Tai; Dharmendra Verma; Mamina Sahoo; Ying-Feng Chang; Hanyuan Liang; Shiwei Feng; Lain-Jong Li; Tuo-Hung Hou; Chao-Sung Lai, Memristive True Random Number Generator with Intrinsic Two-Dimensional Physical Unclonable Function, ACS Appl. Electron. Mater. 2023, 5, 2, 714-720

SUMMARY OF THE INVENTION

One technical problem to be solved by the present invention is to provide a ferroelectric structure including a two-dimensional ferroelectric material and a method for manufacturing the same.

Another technical problem to be solved by the present invention is to provide a ferroelectric structure in which a current value of random intensity is obtained for the same voltage being applied, and a method for manufacturing the same.

Still another technical problem to be solved by the present invention is to provide a ferroelectric structure capable of implementing a true random number generator (TRNG) through a single device and a method for manufacturing the same.

Still another technical problem to be solved by the present invention is to provide a method for deriving an ideal operating voltage and read voltage such that a ferroelectric structure may have an ideal random number generation performance.

Still another technical problem to be solved by the present invention is to provide a ferroelectric structure that may be easily applied to data encryption and encryption key generation for data security.

Still another technical problem to be solved by the present invention is to provide a ferroelectric structure that may be easily applied to simulation data generation using random sampling of repetitive data.

Still another technical problem to be solved by the present invention is to provide a solar cell to which the above-described ferroelectric structure is applied.

Still another technical problem to be solved by the present invention is to provide a non-volatile RF switch to which the above-described ferroelectric structure is applied.

The technical problems to be solved by the present invention are not limited to those described above.

To solve the above technical problems, the present invention provides a ferroelectric structure.

According to one embodiment, the ferroelectric structure may include: a substrate; a lower electrode disposed on the substrate; a ferroelectric layer disposed on the lower electrode and including molybdenum disulfide ($MoS_2$); and an upper electrode disposed on the ferroelectric layer, in which a current value of random intensity is obtained for a same voltage being applied.

According to one embodiment, in the ferroelectric structure, when the same voltage is applied multiple times, current values having mutually different intensities may be generated for each applied voltages.

According to one embodiment, in the ferroelectric structure, when a voltage is applied, polarization may occur in the ferroelectric structure.

According to one embodiment, in the ferroelectric structure, a current value of random intensity may be obtained for the same voltage being applied due to the polarization occurring in the ferroelectric layer.

According to one embodiment, the ferroelectric structure may be applied to a true random number generator.

According to another embodiment, the ferroelectric structure may include: a substrate; a lower electrode disposed on the substrate; a ferroelectric layer disposed on the lower electrode and including a two-dimensional ferroelectric material; and an upper electrode disposed on the ferroelectric layer, in which a current value of random intensity is obtained for the same voltage being applied.

According to another embodiment, in the ferroelectric structure, when the same voltage is applied multiple times, current values having mutually different intensities may be generated for each applied voltage.

According to another embodiment, in the ferroelectric structure, when a voltage is applied, polarization may occur in the ferroelectric structure.

According to another embodiment, in the ferroelectric structure, when a voltage is applied, polarization may occur in the ferroelectric structure.

According to another embodiment, the two-dimensional ferroelectric material may include a compound of mutually different elements, and when the voltage is applied, a position of any one element ion of the mutually different elements included in the two-dimensional ferroelectric material may be changed in the ferroelectric layer.

According to another embodiment, in the ferroelectric structure, a crystal structure of the ferroelectric layer may be changed due to the element ion that changes the position in the ferroelectric layer.

According to another embodiment, the ferroelectric layer may be changed from a symmetric crystal structure to an antisymmetric crystal structure.

According to another embodiment, the ferroelectric structure may be applied to a true random number generator.

To solve the above technical problems, the present invention provides a method for manufacturing a ferroelectric structure.

According to one embodiment, the method for manufacturing a ferroelectric structure may include: preparing a substrate; forming a lower electrode on the substrate; forming a ferroelectric layer, which includes a two-dimensional ferroelectric material, on the lower electrode; and forming an upper electrode on the ferroelectric layer.

To solve the above technical problems, the present invention provides a method for operating a ferroelectric structure.

According to one embodiment, the method for operating a ferroelectric structure may include: preparing the ferroelectric layer that includes a substrate, a lower electrode disposed on the substrate, a ferroelectric layer disposed on the lower electrode and including a two-dimensional ferroelectric material, and an upper electrode disposed on the ferroelectric layer; applying an operating voltage to the ferroelectric structure such that polarization occurs in the ferroelectric layer; applying a read voltage to the ferroelectric structure to obtain a current value reflecting a polarization state of the ferroelectric layer; and applying an erase voltage to the ferroelectric structure such that the ferroelectric layer is restored to a state before the polarization.

According to one embodiment, the applying of the operating voltage, the obtaining of the current value, and the applying of the erase voltage are sequentially repeated while an equal operating voltage may be repeatedly applied.

The ferroelectric structure according to the embodiment of the present invention may include: a substrate; a lower electrode disposed on the substrate; a ferroelectric layer disposed on the lower electrode and including a two-dimensional ferroelectric material; and an upper electrode disposed on the ferroelectric layer, in which a current value of random intensity is obtained for the same voltage being applied.

Therefore, when the ferroelectric structure according to the embodiment is used, the true random number generator may be implemented as a single device. In addition, the ferroelectric structure may be easily applied to data encryption for data security, encryption key generation, simulation data generation using random sampling of repetitive data, etc.

BRIEF DESCRIPTION OF THE DRAWINGS

FIG. 1 is a flowchart for explaining a method for manufacturing a ferroelectric structure according to an embodiment of the present invention.
FIG. 2 is a schematic view for explaining step S110 in the method for manufacturing a ferroelectric structure according to the embodiment of the present invention.
FIG. 3 is a schematic view for explaining step S120 in the method for manufacturing a ferroelectric structure according to the embodiment of the present invention.
FIG. 4 is a schematic view for explaining step S130 in the method for manufacturing a ferroelectric structure according to the embodiment of the present invention.
FIG. 5 is a schematic view for explaining step S140 in the method for manufacturing a ferroelectric structure according to the embodiment of the present invention.
FIG. 6 is a flowchart for explaining a method for operating a ferroelectric structure according to an embodiment of the present invention.
FIG. 7 is a view for explaining a ferroelectric structure according to a first modification example of the present invention.
FIG. 8 is a view for explaining a ferroelectric structure according to a second modification example of the present invention.
FIG. 9 is a schematic sectional view for explaining a ferroelectric structure according to a third modification example of the present invention.
FIG. 10 is a schematic plan view for explaining the ferroelectric structure according to the third modification example of the present invention.
FIG. 11 is a schematic view and an optical image of a ferroelectric structure according to an experimental example of the present invention.
FIG. 12 is a view schematically showing AFM measurement for a ferroelectric layer of the ferroelectric structure according to the experimental example of the present invention.
FIG. 13 is an image showing thickness and surface roughness of the ferroelectric layer measured using AFM.
FIG. 14 is a schematic view of an LGD double well model for a CIPS material used as the ferroelectric layer according to the experimental example of the present invention.
FIG. 15 is a schematic view of a P-V relationship of the ferroelectric layer according to the experimental example of the present invention.
FIG. 16 is a view for explaining a PFM analysis result in a state in which no voltage is applied to the ferroelectric structure according to the experimental example of the present invention.
FIG. 17 is a view for explaining a PFM analysis result in a state in which a voltage of 3 V is applied to the ferroelectric structure according to the experimental example of the present invention.
FIG. 18 is a view for explaining a PFM analysis result in a state in which a voltage of 4 V is applied to the ferroelectric structure according to the experimental example of the present invention.
FIG. 19 is a view for explaining a PFM analysis result in a state in which a voltage of 5 V is applied to the ferroelectric structure according to the experimental example of the present invention.
FIG. 20 is a view for explaining a PFM analysis result in a state in which a voltage of 10 V is applied to the ferroelectric structure according to the experimental example of the present invention.
FIG. 21 is a view showing current-voltage characteristics of the ferroelectric structure according to the experimental example of the present invention.

FIG. 22 is a view for explaining a voltage application process for obtaining a random current signal through the ferroelectric structure according to the experimental example of the present invention.

FIG. 23 is a view showing a current value measured in a state in which an operating voltage of 3 V and a read voltage of 0.5 V are applied for 784 cycles.

FIG. 24 is a view showing a current distribution histogram based on results of FIG. 23.

FIG. 25 is a view showing a current value measured in a state in which an operating voltage of 3 V and a read voltage of 1.0 V are applied for 784 cycles.

FIG. 26 is a view showing a current distribution histogram based on results of FIG. 25.

FIG. 27 is a view showing a current value measured in a state in which an operating voltage of 3 V and a read voltage of 1.5 V are applied for 784 cycles.

FIG. 28 is a view showing a current distribution histogram based on results of FIG. 27.

FIG. 29 is a view showing a current value measured in a state in which an operating voltage of 4 V and a read voltage of 0.5 V are applied for 784 cycles.

FIG. 30 is a view showing a current distribution histogram based on results of FIG. 29.

FIG. 31 is a view showing a current value measured in a state in which an operating voltage of 4 V and a read voltage of 1.0 V are applied for 784 cycles.

FIG. 32 is a view showing a current distribution histogram based on results of FIG. 31.

FIG. 33 is a view showing a current value measured in a state in which an operating voltage of 4 V and a read voltage of 1.5 V are applied for 784 cycles.

FIG. 34 is a view showing a current distribution histogram based on results of FIG. 33.

FIG. 35 is a view showing a current value measured in a state in which an operating voltage of 5 V and a read voltage of 0.5 V are applied for 784 cycles.

FIG. 36 is a view showing a current distribution histogram based on results of FIG. 35.

FIG. 37 is a view showing a current value measured in a state in which an operating voltage of 5 V and a read voltage of 1.0 V are applied for 784 cycles.

FIG. 38 is a view showing a current distribution histogram based on results of FIG. 37.

FIG. 39 is a view showing a current value measured in a state in which an operating voltage of 5 V and a read voltage of 1.5 V are applied for 784 cycles.

FIG. 40 is a view showing a current distribution histogram based on results of FIG. 39.

FIG. 41 is a view for explaining binarization and key classification processes for a random current value through the ferroelectric structure according to the experimental example of the present invention.

FIG. 42 is a view showing binarization and key classification results for a case in which an operating voltage of 3 V is applied as an image.

FIG. 43 is a view showing binarization and key classification results for a case in which an operating voltage of 4 V is applied as an image.

FIG. 44 is a view showing binarization and key classification results for a case in which an operating voltage of 5 V is applied as an image.

FIG. 45 is a view showing a histogram of current values obtained from mutually different read voltages.

FIG. 46 is a view showing a parallax plot of current fluctuation for a read voltage of 0.5 V.

FIG. 47 is a view showing a parallax plot of current fluctuation for a read voltage of 1.0 V.

FIG. 48 is a view showing a parallax plot of current fluctuation for a read voltage of 1.5 V.

FIG. 49 is a view showing a magnitude of current fluctuation according to a read voltage intensity.

FIG. 50 is a view showing a uniformity value and an entropy value derived in a state in which an operating voltage of 3 V and a read voltage of 0.5 V are applied.

FIG. 51 is a view showing a uniformity value and an entropy value derived in a state in which an operating voltage of 3 V and a read voltage of 1.0 V are applied.

FIG. 52 is a view showing a uniformity value and an entropy value derived in a state in which an operating voltage of 3 V and a read voltage of 1.5 V are applied.

FIG. 53 is a view showing a uniformity value and an entropy value derived in a state in which an operating voltage of 4 V and a read voltage of 0.5 V are applied.

FIG. 54 is a view showing a uniformity value and an entropy value derived in a state in which an operating voltage of 4 V and a read voltage of 1.0 V are applied.

FIG. 55 is a view showing a uniformity value and an entropy value derived in a state in which an operating voltage of 4 V and a read voltage of 1.5 V are applied.

FIG. 56 is a view showing a uniformity value and an entropy value derived in a state in which an operating voltage of 5 V and a read voltage of 0.5 V are applied.

FIG. 57 is a view showing a uniformity value and an entropy value derived in a state in which an operating voltage of 5 V and a read voltage of 1.0 V are applied.

FIG. 58 is a view showing a uniformity value and an entropy value derived in a state in which an operating voltage of 5 V and a read voltage of 1.5 V are applied.

FIG. 59 is a view visualizing uniformity values at mutually different operating voltages and read voltages.

FIG. 60 is a view visualizing entropy values at mutually different operating voltages and read voltages.

FIG. 61 is a view showing a Hamming distance histogram of the ferroelectric structure according to the experimental example of the present invention.

FIG. 62 is a view visualizing average Hamming distance values at mutually different operating voltages and read voltages.

FIG. 63 is a view showing an image in which a n value is estimated using a Monte-Carlo simulation.

FIG. 64 is a view showing an autocorrelation image for each different key of the ferroelectric structure according to the experimental example of the present invention.

FIG. 65 is a view showing a correlation coefficient histogram of the ferroelectric structure according to the experimental example of the present invention.

FIG. 66 is a view visualizing average correlation coefficient values at mutually different operating voltages and read voltages.

FIG. 67 is a view for explaining results of evaluating international standard encryption performance according to Experimental Example 6.

FIG. 68 is a view showing a Hamming distance histogram between 28 keys obtained from 10 mutually different pairs of ferroelectric structures.

FIG. 69 is a view visualizing average Hamming distance values at 10 mutually different pairs of ferroelectric structures.

FIG. 70 is a view showing a Hamming distance histogram between 28 keys obtained from 10 mutually different pairs of ferroelectric structures.

FIG. 71 is a view visualizing average correlation coefficient values at 10 mutually different pairs of ferroelectric structures.

## DETAILED DESCRIPTION OF THE INVENTION

Hereinafter, preferred embodiments of the present invention will be described in detail with reference to the accompanying drawings. However, the present invention may be embodied in different forms and should not be construed as limited to the embodiments set forth herein. Rather, the embodiments are provided so that this disclosure will be thorough and complete, and will fully convey the scope of the present invention to those skilled in the art.

In the present specification, it will be understood that when an element is referred to as being "on" another element, it can be formed directly on the other element or intervening elements may be present. In the drawings, the thicknesses of layers and regions are exaggerated for clarity.

In addition, it will be also understood that although the terms first, second, third, etc. may be used herein to describe various elements, these elements should not be limited by these terms. These terms are only used to distinguish one element from another element. Thus, a first element in some embodiments may be termed a second element in other embodiments without departing from the teachings of the present invention. Embodiments explained and illustrated herein include their complementary counterparts. As used herein, the term "and/or" includes any and all combinations of one or more of the associated listed elements.

The singular expression also includes the plural meaning as long as it does not differently mean in the context. In addition, the terms "comprise", "have" etc., of the description are used to indicate that there are features, numbers, steps, elements, or combinations thereof, and they should not exclude the possibilities of combination or addition of one or more features, numbers, operations, elements, or a combination thereof. Furthermore, it will be understood that when an element is referred to as being "connected" or "coupled" to another element, it may be directly connected or coupled to the other element or intervening elements may be present.

In addition, when detailed descriptions of related known functions or constitutions are considered to unnecessarily cloud the gist of the present invention in describing the present invention below, the detailed descriptions will not be included.

Ferroelectric Structure, Method for Manufacturing Same, And Method for Operating Same

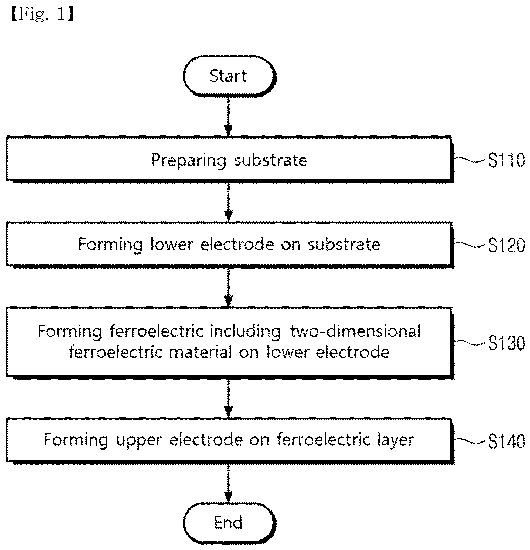

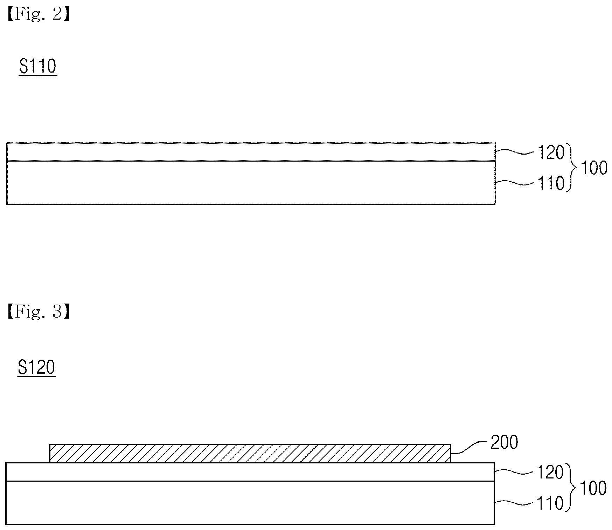

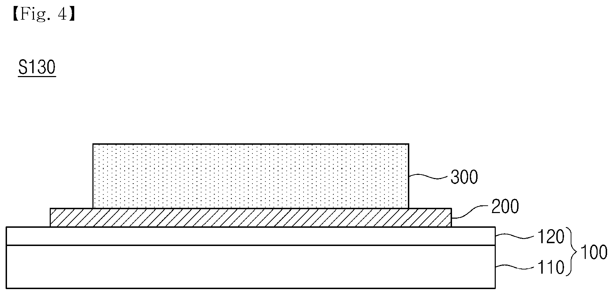

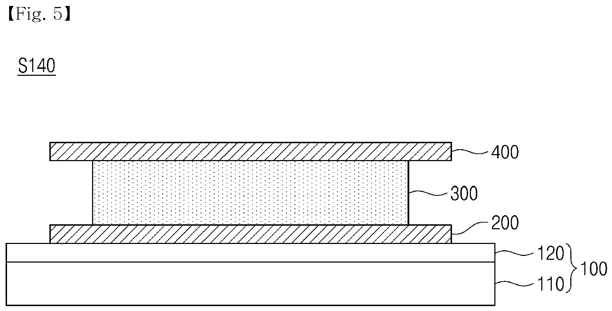

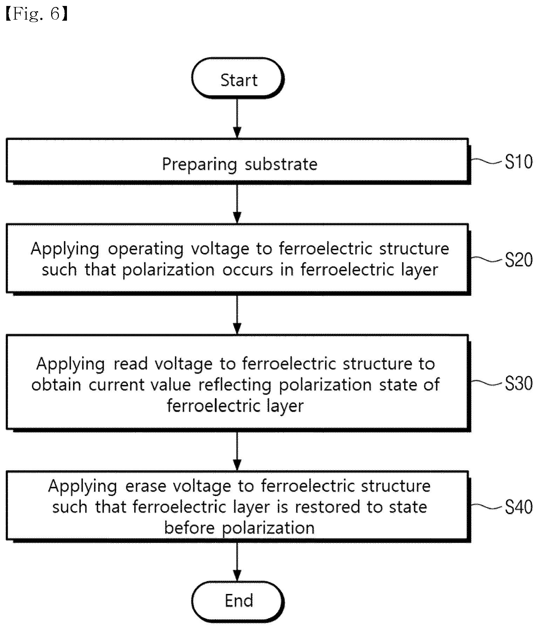

FIG. 1 is a flowchart for explaining a method for manufacturing a ferroelectric structure according to an embodiment of the present invention, FIG. 2 is a schematic view for explaining step S110 in the method for manufacturing a ferroelectric structure according to the embodiment of the present invention, FIG. 3 is a schematic view for explaining step S120 in the method for manufacturing a ferroelectric structure according to the embodiment of the present invention, FIG. 4 is a schematic view for explaining step S130 in the method for manufacturing a ferroelectric structure according to the embodiment of the present invention, FIG. 5 is a schematic view for explaining step S140 in the method for manufacturing a ferroelectric structure according to the embodiment of the present invention, and FIG. 6 is a flowchart for explaining a method for operating a ferroelectric structure according to an embodiment of the present invention.

Referring to FIGS. 1 and 2, a substrate 100 may be prepared (S110). According to one embodiment, the substrate 100 may be a silicon semiconductor substrate. More specifically, the substrate 100 may be a substrate having a silicon oxide ($SiO_2$) layer 120 formed on a silicon (Si) substrate 110. Alternatively, according to another embodiment, the substrate 100 may be a compound semiconductor substrate. Alternatively, according to still another embodiment, the substrate 100 may be a glass substrate. Alternatively, according to still another embodiment, the substrate 100 may be a plastic substrate. The type of the substrate 100 is not limited.

Referring to FIGS. 1 and 3, a lower electrode 200 may be formed on the substrate 100 (S120). According to one embodiment, the lower electrode 200 may include metal. For example, the lower electrode 200 may include gold (Au). According to one embodiment, the lower electrode 200 may be formed by E-beam lithography and E-beam deposition. The above-described method and material for forming the lower electrode 200 are exemplary, and the method and type of the material for forming the lower electrode 200 are not limited.

Referring to FIGS. 1 and 4, a ferroelectric layer 300 may be formed on the lower electrode 200 (S130). According to one embodiment, the ferroelectric layer 300 may include a two-dimensional ferroelectric material. Further, the two-dimensional ferroelectric material may include a compound of mutually different elements. For example, the ferroelectric layer may include any one of molybdenum disulfide ($MoS_2$), hafnium oxide ($HfO_2$), and $CuInP_2S_6$ (CIPS).

According to one embodiment, the ferroelectric layer 300 may be formed by a method for dry-transferring the two-dimensional ferroelectric material, which is mechanically peeled off from a bulk, onto the lower electrode 200. The method for forming the ferroelectric layer 300 is not limited.

Referring to FIGS. 1 and 5, an upper electrode 400 may be formed on the ferroelectric layer 300 (S140). Accordingly, a ferroelectric structure according to the embodiment may be manufactured. According to one embodiment, the upper electrode 400 may include metal. For example, the upper electrode 400 may include gold (Au). According to one embodiment, the upper electrode 400 may be formed by E-beam lithography and E-beam deposition. The above-described method and material for forming the upper electrode 400 are exemplary, and the method and type of the material for forming the upper electrode 400 are not limited.

When a voltage is applied to the ferroelectric structure, a position of any one element ion of mutually different elements included in the two-dimensional ferroelectric material of the ferroelectric layer 300 may be changed in the ferroelectric layer 300. For example, when the ferroelectric layer 300 includes $CuInP_2S_6$ (CIPS) as the two-dimensional ferroelectric material, a position of copper ion (Cu+) in the ferroelectric layer 300 may be changed as the voltage is applied to the ferroelectric structure.

Further, a crystal structure of the ferroelectric layer 300 may be changed due to the element ion that changes the position in the ferroelectric layer 300. For example, when the position of copper ion (Cu+) in the ferroelectric layer 300 is changed, the crystal structure of the ferroelectric layer 300 may be changed from a symmetrical crystal structure to an antisymmetric crystal structure.

Moreover, as the crystal structure of the ferroelectric layer 300 is changed, polarization occurs in the ferroelectric layer 300. For example, out-of-plane (OOP) polarization may occur in the ferroelectric layer 300 including $CuInP_2S_6$ (CIPS).

That is, when a voltage is applied to the ferroelectric structure, a position of any one element ion (e.g., Cu+ ion) of the mutually different elements included in the two-dimensional ferroelectric material (e.g., CIPS) of the ferroelectric layer 300 is changed in the ferroelectric layer 300 to change the crystal structure of the ferroelectric layer 300 (e.g., change from the symmetrical crystal structure to the anti-symmetrical crystal structure), and thus polarization may occur in the ferroelectric layer 300 (e.g., out-of-plane polarization may occur).

In describing the present invention, the "polarization" may mean a phenomenon in which positions of negative charges and positive charges are separated in an electric field to have a dipole moment. In addition, the "In-plane (IP) polarization" may mean a phenomenon in which the positions of negative charges and positive charges are separated along a direction parallel to an upper surface or lower surface of the ferroelectric layer 300 to have a dipole moment. In addition, the "out-of-plane (OOP) polarization' may mean a phenomenon in which the positions of negative charges and positive charges are separated along a direction perpendicular to the upper surface or lower surface of the ferroelectric layer 300, that is, a thickness direction of the ferroelectric layer 300 to have a dipole moment.

As described above, in a process in which polarization occurs due to a change in the crystal structure of the ferroelectric layer 300 as the position of a specific element ion in the ferroelectric layer 300 is changed, a random domain change may occur in the ferroelectric layer 300. More specifically, as partial polarization occurs in the ferroelectric layer 300, the random domain change may occur in the ferroelectric layer 300.

In describing the present invention, the "partial polarization" may mean a state in which dipoles with mutually different arrangement directions are mixed. For example, when the out-of-plane (OOP) polarization occurs in the ferroelectric layer 300, the state, in which a dipole arranged upward (up) (e.g., arranged such that the positive charges are directed to the upper surface and the negative charges are directed to the lower surface) and a dipole arranged downward (bottom) (e.g., arranged such that the negative charges are directed to the upper surface and the positive charges are directed to the lower surface) are mixed, is defined as a partial polarization state. Accordingly, the occurrence of random partial polarization may mean a state in which a positional distribution of the dipoles arranged upward and the dipoles arranged downward in the ferroelectric layer 300 is randomly formed and a state in which a ratio of each of the dipoles arranged upward and the dipoles arranged downward in the ferroelectric layer 300 is randomly changed.

That is, even if the same voltage is repeatedly applied to the ferroelectric structure, mutually different domain states and mutually different polarization states may be formed in the ferroelectric layer 300 for each applied voltage (random domain states and random polarization states may be formed). Therefore, the ferroelectric structure may obtain a current value of random intensity for the same voltage being applied. In other words, even if the same voltage is applied to the ferroelectric structure multiple times, current values of mutually different intensities may be generated for each applied voltage. Due to characteristics as described above, the ferroelectric structure may be applied to a true random number generator.

According to one embodiment, a power application unit (not shown) and a random number generation unit (not shown) may be connected to an input terminal and an output terminal of the ferroelectric structure, respectively. For example, when the lower electrode 200 is used as the input terminal and the upper electrode 400 is used as the output terminal, the power application unit may be connected to the lower electrode 200, and the random number generation unit may be connected to the upper electrode 400. Alternatively, when the upper electrode 400 is used as the input terminal and the lower electrode 200 is used as the output terminal, the power application unit may be connected to the upper electrode 400, and the random number generation unit may be connected to the lower electrode 200. The power application unit may apply an input voltage of less than a threshold voltage, and the random number generation unit may generate a random number according to a magnitude of an output current corresponding to the input voltage.

According to one embodiment, a method for operating the ferroelectric structure to obtain random current data through the ferroelectric structure may be performed through a sequence as shown in FIG. 6.

Specifically, referring to FIG. 6, the ferroelectric structure may be prepared (S10). The ferroelectric structure prepared in step S10 may be the same as the ferroelectric structure manufactured by the method described with reference to FIGS. 1 to 5.

An operating voltage $V_{program}$ may be applied to the ferroelectric structure such that polarization occurs in the ferroelectric layer 300 (S20). According to one embodiment, the operating voltage may be selected within a range from a coercive voltage to a saturation voltage. According to one embodiment, the coercive voltage may be defined as a voltage at the moment when specific ions (e.g., Cu+ ions) in the ferroelectric layer 300 start to move. According to one embodiment, the saturation voltage may be defined as a voltage at the moment when specific ions (e.g., Cu+ ions) in the ferroelectric layer 300 completely move after the movement of the specific ions (e.g., Cu+ ions), and thus no further movement of the specific ions (e.g., Cu+ ions) occurs.

For example, the operating voltage may be selected within a range from the coercive voltage to the saturation voltage, and may be selected as a voltage capable of moving specific ions (e.g., Cu+ ions) by 50%. Alternatively, for another example, the operating voltage may be selected within a range from the coercive voltage to the saturation voltage, and may be selected as a voltage capable of forming a domain in the ferroelectric layer 300 by 50%.

After step S20 of applying the operating voltage to the ferroelectric structure, a current value reflecting the polarization state of the ferroelectric layer 300 may be obtained by applying a read voltage $V_{read}$ to the ferroelectric structure (S30) . Thereafter, an erase voltage $V_{erase}$ may be applied to the ferroelectric structure such that the ferroelectric layer 300 is restored to a state before the polarization.

The step S20 of applying the operating voltage, the step S30 of obtaining the current value, and the step S40 of applying the erase voltage may be sequentially repeated, and the same operating voltage may be repeatedly applied, and current values for respective applied operating values may be obtained, thereby obtaining random current data through the ferroelectric structure.

In addition, according to one embodiment, the present invention may derive the ideal operating voltage and read voltage such that the ferroelectric structure may have an ideal random number generation performance.

More specifically, in the method for operating a ferroelectric structure, an average current value may be derived for a plurality of current values obtained in step S30, and bit data may be generated by binarizing each of the plurality of current values obtained in step S30 based on the derived average current value. For example, the bit data may be generated by binarizing a current value greater than or equal to the average current value into a state of "1" and binarizing a current value less than the average current value into a state of "0".

After the bit data is generated through binarization, the generated bit data may be classified into a plurality of keys. For example, 28 bits of the generated 784 bits may be configured as one key and classified as a total of 28 keys.

After the keys are classified, the classified keys may be evaluated, and an operating voltage and a read voltage satisfying the evaluation may be derived. For example, for the classified keys, an operating voltage and a read voltage having a uniformity value of 0.5, which is calculated according to the following Equation 1, and an entropy value of 1, which is calculated according to the following Equation 2, may be derived. In a case of the ideal random number generator, since the expression possibility in a state of 0 and the expression possibility in a state of 1 are equal to 50%, the operating voltage and the read voltage having the uniformity value of 0.5 and the entropy value of 1 may be derived as ideal values.

<Equation 1>

$$U = N(state1)/[N(state1) + N(state0)]$$

(U: Uniformity, N(state1): Expression possibility in state of 1, N(state0): Expression possibility in state of 0

<Equation 2>

$$E = -[\text{plog}_2 p + (1 - p) \log_2(1 - p)]$$

(E: Entropy, p: Expression possibility in state of 1, 1-p: Expression possibility in state of 0)

As a result of deriving the ideal operating voltage and read voltage for the ferroelectric structure including the $CuInP_2S_6$ (CIPS) ferroelectric layer through the method as described above, the operating voltage may be derived as 4 V and the read voltage may be derived as 1.5 V. That is, the operating voltage of 4 V and the read voltage of 1.5 V are applied to the ferroelectric structure including the $CuInP_2S_6$ (CIPS) ferroelectric layer, a true random number generator having an ideal random number generation performance may be implemented.

As a result, the ferroelectric structure according to the embodiment of the present invention may include: the substrate 100; the lower electrode 200 disposed on the substrate 100; the ferroelectric layer 300 disposed on the lower electrode 200 and including the two-dimensional ferroelectric material; and the upper electrode 400 disposed on the ferroelectric layer 300, in which the current value of random intensity may be obtained for the same voltage being applied.

Therefore, when the ferroelectric structure according to the embodiment is used, the true random number generator may be implemented as a single device. In addition, the ferroelectric structure may be easily applied to data encryption for data security, encryption key generation, simulation data generation using random sampling of repetitive data, etc.

Hereinabove, the ferroelectric structure, the method for manufacturing the same, and the method for operating the same according to the embodiment of the present invention have been described. Hereinafter, application examples of a ferroelectric structure (metal/CIPS/metal) according to the embodiment of the present invention in other fields will be described.

According to one embodiment, the ferroelectric structure (metal/CIPS/metal) according to the embodiment of the present invention may be used as a semiconductor layer of a solar cell. More specifically, the ferroelectric structure (metal/CIPS/metal) may be applied to a solar cell having a structure in which a $CuInP_2S_6$(CIPS) semiconductor layer is disposed between an upper electrode and a lower electrode, and may be applied to a solar cell that converts light energy into electrical energy using a photovoltaic effect. As described above, the solar cell that uses $CuInP_2S_6$(CIPS) as a semiconductor layer may exhibit a higher current production ($J_{sc}$/Power) relative to the same applied power as compared to solar cells that use a material other than CIPS as a semiconductor layer.

Alternatively, according to another embodiment, the ferroelectric structure (metal/CIPS/metal) according to the embodiment of the present invention may be applied to a non-volatile RF switch. More specifically, the ferroelectric structure may be applied to a non-volatile RF switch capable of passing an RF signal well with low resistance in an ON state and shielding the RF signal well with high resistance and storage capacity in an OFF state by using a resistance variable non-volatile memory of a capacitor structure.

Hereinabove, various application examples of the ferroelectric structure according to the embodiment of the present invention have been described. Hereinafter, various modification examples of the ferroelectric structure according to the embodiment of the present invention will be described.

**First Modification Example: Ferroelectric Layer Stack Structure**

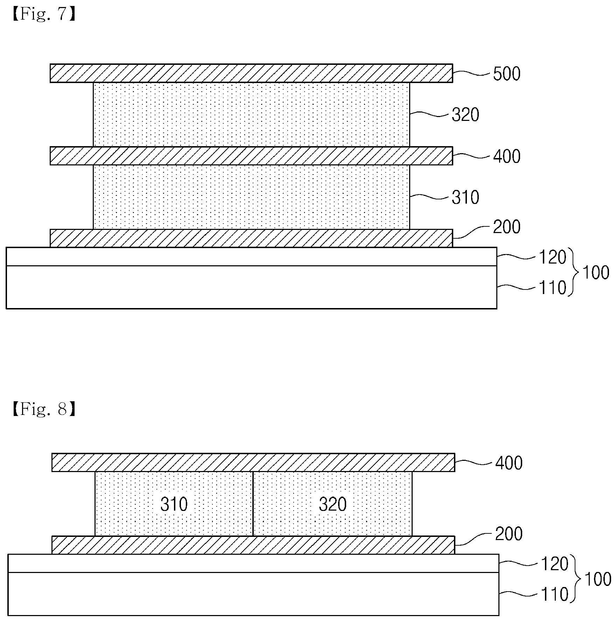

FIG. 7 is a view for explaining a ferroelectric structure according to a first modification example of the present invention.

Referring to FIG. 7, the ferroelectric structure according to the first modification example of the present invention may include: a substrate 100; a lower electrode 200 disposed on the substrate 100; a first ferroelectric layer 310 disposed on the lower electrode 200; an intermediate electrode 400 disposed on the first ferroelectric layer 310; a second ferroelectric layer 320 disposed on the intermediate electrode 400; and an upper electrode 500 disposed on the second ferroelectric layer 320. That is, the ferroelectric structure according to the first modification example may have a structure in which the second ferroelectric layer 320 is stacked on first ferroelectric layer 310.

As described above, when the ferroelectric structure may have the structure in which the second ferroelectric layer 320 is stacked on first ferroelectric layer 310, two random number currents may be obtained through a single input of an operating voltage $V_{program}$ and a read voltage $V_{read}$. Therefore, a random number generation throughput may be improved.

According to one embodiment, the first ferroelectric layer 310 and the second ferroelectric layer 320 may include the same two-dimensional ferroelectric material. For example, both the first ferroelectric layer 310 and the second ferroelectric layer 320 may include $CuInP_2S_6$(CIPS).

According to another embodiment, the first ferroelectric layer 310 and the second ferroelectric layer 320 may include mutually different two-dimensional ferroelectric materials. For example, the first ferroelectric layer 310 may include $CuInP_2S_6$(CIPS), whereas the second ferroelectric layer 320 may include $CuCrP_2S_6$ or $CuInP_2Se_6$.

Further, according to one embodiment, operating voltage scaling may be performed by controlling the thicknesses of the first ferroelectric layer 310 and the second ferroelectric layer 320. More specifically, as the thicknesses of the first ferroelectric layer 310 and the second ferroelectric layer 320 increase, a voltage required to generate polarization may increase. Accordingly, the operating voltage scaling may be performed by increasing the thickness in an encryption situation requiring high-performance computing (HPC) because a high operation is required, and decreasing the thickness in an encryption situation requiring edge computing because a low operating voltage is required.

**Second Modification Example Ferroelectric Layer Split Structure**

FIG. 8 is a view for explaining a ferroelectric structure according to a second modification example of the present invention.

Referring to FIG. 8, the ferroelectric structure according to the second modification example of the present invention may include: a substrate 100; a lower electrode 200 disposed on the substrate 100; a first ferroelectric layer 310 and a second ferroelectric layer 320 disposed on the lower electrode 200; and an upper electrode 400 disposed on the first ferroelectric layer 310 and the second ferroelectric layer 320.

According to one embodiment, the first ferroelectric layer 310 and the second ferroelectric layer 320 may be disposed on the lower electrode 200, and may be disposed side by side along a direction parallel to an upper surface of the lower electrode 200. Further, both a lower surface of the first ferroelectric layer 310 and a lower surface of the second ferroelectric layer 320 may be disposed to make contact with the lower electrode 200, and both an upper surface of the first ferroelectric layer 310 and an upper surface of the second ferroelectric layer 320 may be disposed to make contact with the upper electrode 400. That is, the ferroelectric structure according to the second modification example may have a structure in which the ferroelectric layer 300 is divided into the first ferroelectric layer 310 and the second ferroelectric layer 320, as compared to the ferroelectric structure according to the embodiment.

As described above, when the ferroelectric layer 300 may have the structure in which the ferroelectric layer 300 is divided into the first ferroelectric layer 310 and the second ferroelectric layer 320, domain randomness may occur from each of the first ferroelectric layer 310 and the second ferroelectric layer 320. Accordingly, random numbers may be generated from the first ferroelectric layer 310 and the second ferroelectric layer 320, respectively, so that overall random number generation efficiency may be improved.

According to one embodiment, the first ferroelectric layer 310 and the second ferroelectric layer 320 may include the same two-dimensional ferroelectric material. For example, both the first ferroelectric layer 310 and the second ferroelectric layer 320 may include $CuInP_2S_6$(CIPS).

According to another embodiment, the first ferroelectric layer 310 and the second ferroelectric layer 320 may include mutually different two-dimensional ferroelectric materials. For example, the first ferroelectric layer 310 may include $CuInP_2S_6$(CIPS), whereas the second ferroelectric layer 320 may include $CuCrP_2S_6$ or $CuInP_2Se_6$. As described above, when the first ferroelectric layer 310 and the second ferroelectric layer 320 include mutually different two-dimensional ferroelectric materials, it may be more difficult to expect the same result in a device having the same structure, so that the problem of device replication may be solved, and randomness may also be enhanced.

**Third Modification Example Upper Electrode Split Structure**

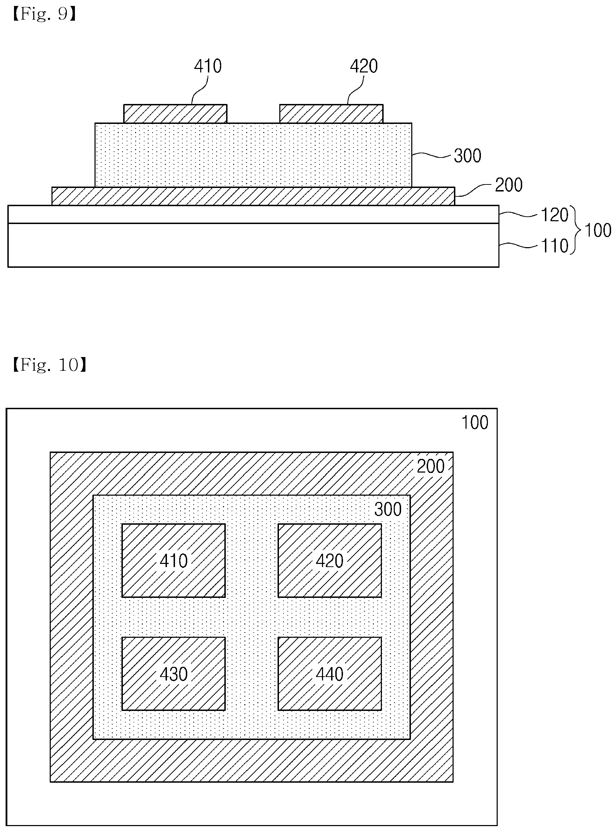

FIG. 9 is a schematic sectional view for explaining a ferroelectric structure according to a third modification example of the present invention, and FIG. 10 is a schematic plan view for explaining the ferroelectric structure according to the third modification example of the present invention.

Referring to FIGS. 9 and 10, the ferroelectric structure according to the third modification example of the present invention may include: a substrate 100; a lower electrode 200 disposed on the substrate 100; a ferroelectric layer 300 disposed on the lower electrode 200; and a first upper electrode 410, a second upper electrode 420, a third upper electrode 430, and a fourth upper electrode 440 disposed on the ferroelectric layer 300.

According to one embodiment, the first upper electrode 410, the second upper electrode 420, the third upper electrode 430, and the fourth upper electrode 440 may be disposed on the ferroelectric layer 300, and may be disposed to be spaced apart from each other. That is, the ferroelectric structure according to the third modification example may have a structure in which the upper electrode 400 is divided into the first upper electrode 410, the second upper electrode 420, the third upper electrode 430, and the fourth upper electrode 440, as compared to the ferroelectric structure according to the embodiment.

As described above, when the ferroelectric structure may have the structure in which the upper electrode 400 is divided into the first upper electrode 410, the second upper electrode 420, the third upper electrode 430, and the fourth upper electrode 440, random number generation efficiency may be improved by selection randomness of the first to fourth upper electrodes 410 to 440 and domain randomness of the ferroelectric layer 300.

According to one embodiment, all of the first to fourth upper electrodes 410 to 440 may include the same metal. For example, all of the first to fourth upper electrodes 410 to 440 may include gold (Au).

According to one embodiment, all of the first to fourth upper electrodes 410 to 440 may have mutually different sizes of areas (sizes of areas making contact with the ferroelectric layer). Accordingly, since the number of cases for selecting an electrode may be increased, randomness may be enhanced, and a use area of a material in a process of generating a password with respect to the same input signal may be effectively controlled, thereby improving a lifespan of a device.

Hereinabove, various modification examples of the ferroelectric structure according to the embodiment of the present invention have been described. Hereinafter, specific experimental examples and characteristic evaluation results of the ferroelectric structure according to the embodiment of the present invention will be described.

Experimental Example 1: Manufacture And Structure Confirmation of Ferroelectric Structure

A gold (Au) electrode was deposited on a $SiO_2$/Si substrate by E-beam lithography and E-beam deposition to form a lower electrode. Thereafter, $CuInP_2S_6$ (CIPS) was secured through a physical exfoliation method, and the secured $CuInP_2S_6$ (CIPS) was transferred onto the lower electrode by a dry transfer method to form a ferroelectric layer. Finally, the gold (Au) electrode was deposited on the ferroelectric layer as an upper electrode by E-beam lithography and E-beam deposition.

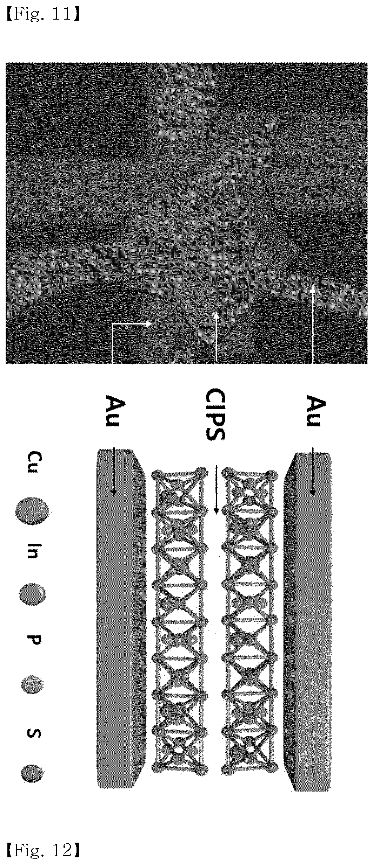

FIG. 11 is a schematic view and an optical image of a ferroelectric structure according to an experimental example of the present invention.

Referring to FIG. 11, it shows a schematic view (right side) and an optical image (left side) of the ferroelectric structure according to the experimental example. As can be seen from FIG. 11, a $CuInP_2S_6$ (CIPS) ferroelectric layer was formed between the upper electrode and the lower electrode.

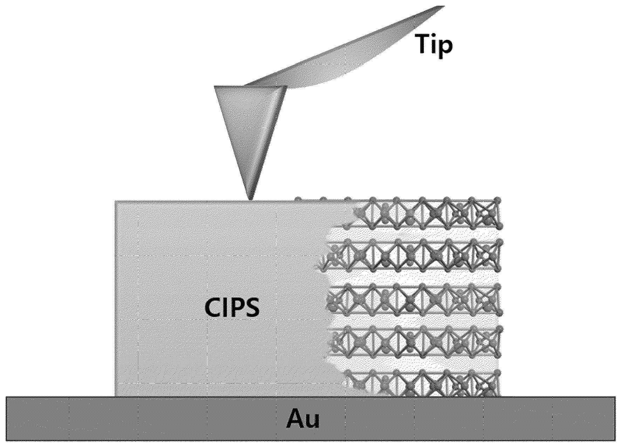

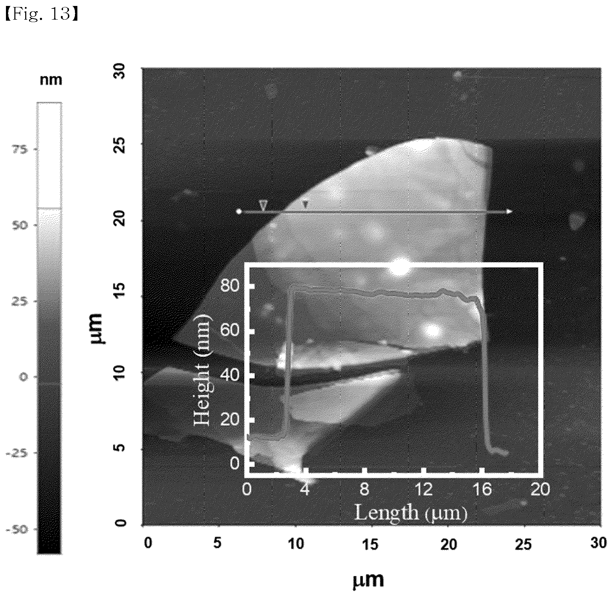

FIG. 12 is a view schematically showing AFM measurement for a ferroelectric layer of the ferroelectric structure according to the experimental example of the present invention, and FIG. 13 is an image showing thickness and surface roughness of the ferroelectric layer measured using AFM.

Referring to FIGS. 12 and 13, atomic force microscopy (AFM) measurement was performed on the ferroelectric layer of the ferroelectric structure according to the experimental example to confirm thickness and surface roughness. More specifically, scanning was performed in a 30 x 30 $\mu m^2$ area of the ferroelectric layer. As shown in FIG. 13, scanning was performed along a red line, and it can be confirmed from a height (nm) profile confirmed through the scanning that the ferroelectric layer has a thickness of about 80 nm.

Experimental Example 2: Evaluation of Electrical Polarization Characteristics of Ferroelectric Structure

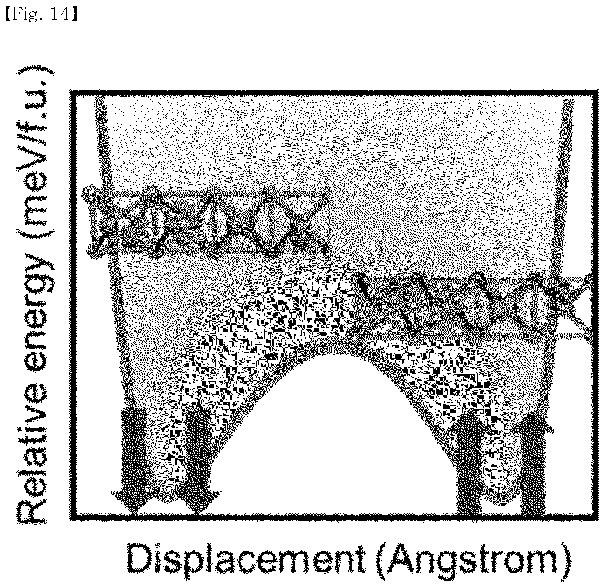

FIG. 14 is a schematic view of an LGD double well model for a CIPS material used as the ferroelectric layer according to the experimental example of the present invention.

Referring to FIG. 14, it shows a schematic view of a Lindau Ginzberg Devonshire (LGE) double well model showing a stable and complete polarization state in different directions according to a change in position of copper ion (Cu+).

The CIPS material is a crystalline material capable of spontaneous polarization that changes by an external electric field. A lattice structure of the CIPS material includes ionic bonds between [P2S6]4-anions and Cu+ and In2+ cations. A positional deviation of Cu+ ions in each single layer breaks the symmetry of the lattice structure and exhibits a ferroelectric effect in which the polarization state is maintained even when the external electric field disappears.

As can be seen from FIG. 14, the Lindau Ginzberg Devonshire (LGD) double well model shows two thermodynamically equivalent polarization states shown by the CIPS material (a state in which all dipoles are arranged downward and a state in which all dipoles are arranged upward). Therefore, it can be seen that in order to reach another polarization state of the LGD double well model by changing the position of the copper ion (Cu+), it is required to supply external energy in the form of an electric field.

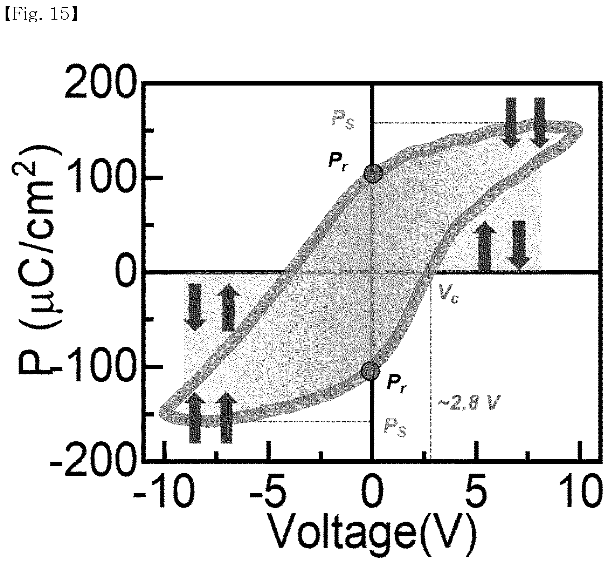

FIG. 15 is a schematic view of a P-V relationship of the ferroelectric layer according to the experimental example of the present invention.

Referring to FIG. 15, it shows a P-V relationship schematic view that shows a degree of polarization (P, $\mu C/cm^2$) generated in the ferroelectric layer according to a voltage (V) applied to the ferroelectric structure according to the experimental example.

As can be seen from FIG. 15, saturated polarization (Ps) occurs as external voltages of 10 V and -10 V are applied, which may mean the moment when the LGD dual well model reaches different stable polarization states. In addition, it can be confirmed that two results in remnant polarization (Pr) condition in which no additional electric field is applied have a value lower than the intensity of the saturated polarized light.

Meanwhile, as for a coercive voltage (Vc) at which alignment of the dipoles inside the ferroelectric layer starts by the programmed electric field, it can be confirmed that the coercive voltages corresponding to both directions are slightly different. This may be caused by various external factors (electrodes, thermal fluctuations, etc.), and may act as a cause for asymmetrically expressing the I-V characteristics of the ferroelectric layer which will be described later.

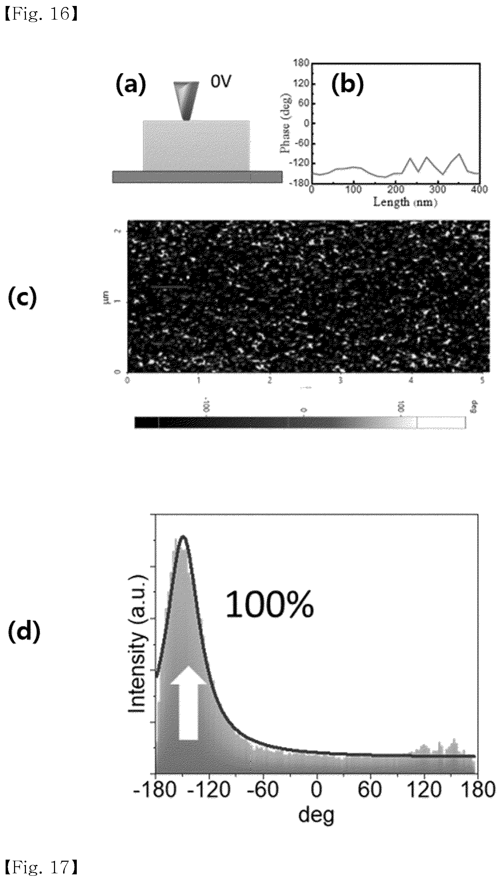

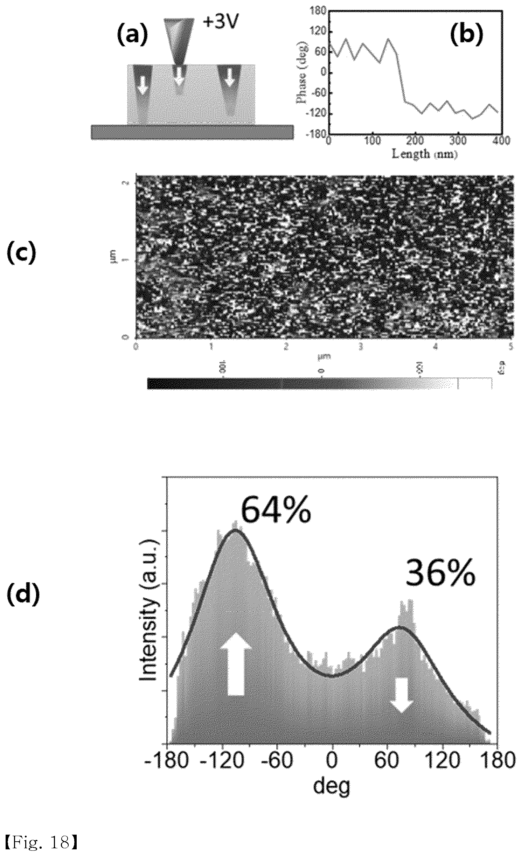

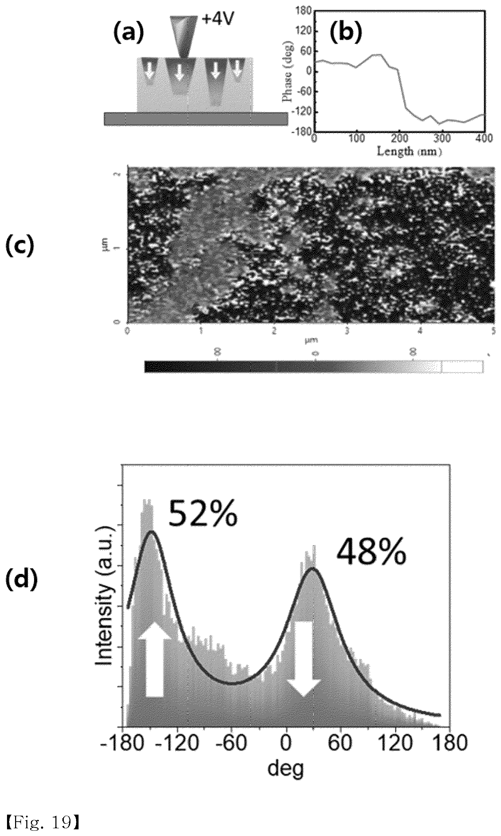

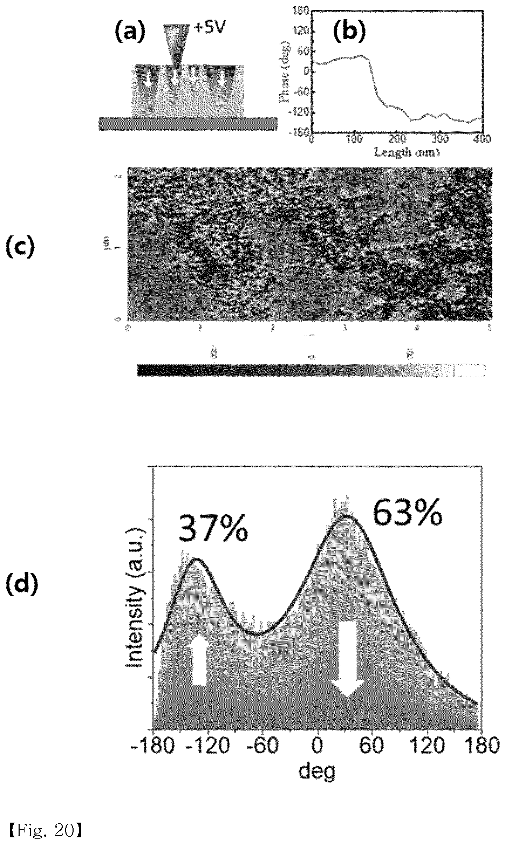

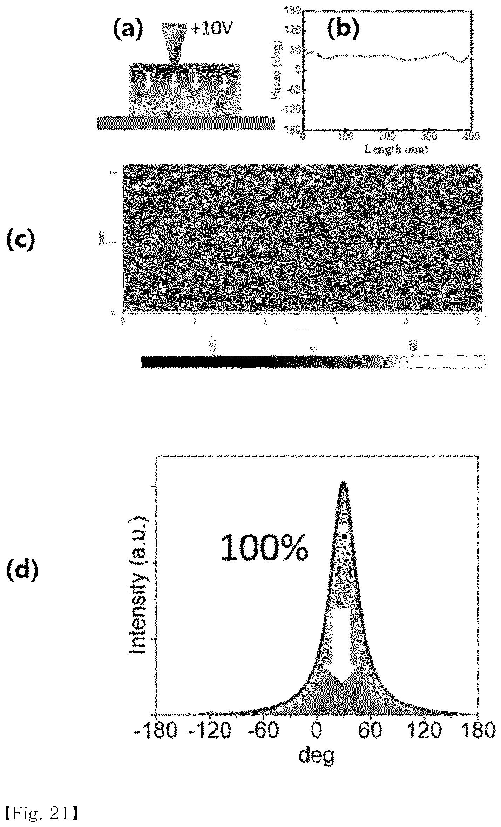

FIG. 16 is a view for explaining a PFM analysis result in a state in which no voltage is applied to the ferroelectric structure according to the experimental example of the present invention, FIG. 17 is a view for explaining a PFM analysis result in a state in which a voltage of 3 V is applied to the ferroelectric structure according to the experimental example of the present invention, FIG. 18 is a view for explaining a PFM analysis result in a state in which a voltage of 4 V is applied to the ferroelectric structure according to the experimental example of the present invention, FIG. 19 is a view for explaining a PFM analysis result in a state in which a voltage of 5 V is applied to the ferroelectric structure according to the experimental example of the present invention, and FIG. 20 is a view for explaining a PFM analysis result in a state in which a voltage of 10 V is applied to the ferroelectric structure according to the experimental example of the present invention.

Referring to FIGS. 16 to 20, in order to confirm a partial polarization phenomenon occurring in the ferroelectric layer according to an external electric field (voltage application), polarization analysis was performed using a piezoresponse force microscopy (PFM) in a 30 x 30 $\mu m^2$ area of the ferroelectric layer. Specifically, (a) of FIGS. 16 to 20 shows a schematic view of a state in which a domain is grown in the ferroelectric layer according to a voltage being applied, (b) of FIGS. 16 to 20 shows a phase (deg) profile according to a length (nm) of the ferroelectric layer, (c) of FIGS. 16 to 20 shows a PFM image of the ferroelectric layer in a state in which a voltage is applied, and (d) of FIGS. 16 to 20 shows an intensity (a.u.) profile according to the phase (deg) .

As can be seen from FIGS. 16 to 20, as the applied voltage increases, a domain formation rate increases. In this case, the bright and dark color contrast appearing in the PFM image shows a phase difference of 180°, which means dipole arrangement or domain formation in an upward direction and a downward direction.

As shown in FIG. 16, it can be confirmed that in the ferroelectric layer (CIPS), all dipoles are aligned upward with 100% probability under a condition in which no external voltage is applied. In contrast, as shown in FIG. 17, it can be confirmed that when a voltage of 3 V, which is greater than the coercive voltage, is applied, dipole arrangement in the ferroelectric layer (CIPS) starts to change, th dipoles arranged upward are present at a probability of 64% and the dipoles arranged downward are present at a probability of 36%. In contrast, as shown in FIG. 18, as a result of increasing the applied voltage to 4 V, it can be confirmed that the dipoles arranged upward are present at 52% and the dipoles arranged downward are present at 48%. In contrast, as shown in FIG. 19, as a result of increasing the applied voltage to 5 V, it can be confirmed that the dipoles arranged upward are present at 37% and the dipoles arranged downward are present at 63%. In contrast, as shown in FIG. 20, as a result of increasing the applied voltage to 10 V, it can be confirmed that all the dipoles are arranged downward at a probability of 100%.

Accordingly, the results confirmed through FIGS. 16 to 20 show a saturation voltage state in which all dipoles are completely polarized in the same direction at a voltage of 10 V, like the polarization-voltage (P-E) result confirmed in FIG. 15. In addition, these results suggest that all domains are not changed by one moment (one voltage application).

Experimental Example 3: Evaluation of Current Characteristics of Ferroelectric Structure and Binarization And Key Classification Based Thereon

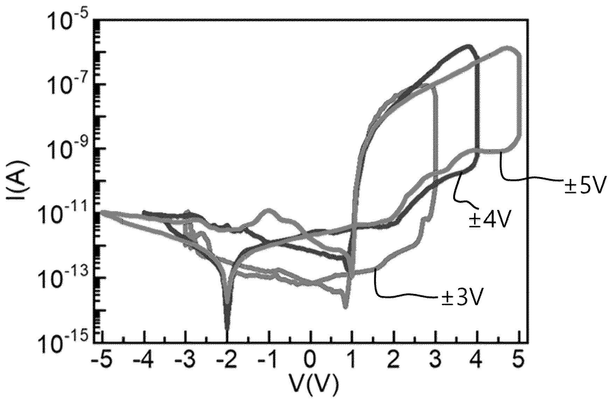

FIG. 21 is a view showing current-voltage characteristics of the ferroelectric structure according to the experimental example of the present invention.

Referring to FIG. 21, it shows a result in which voltages ($\pm 3$ V, $\pm 4$ V, $\pm 5$ V) of different ranges are applied to the ferroelectric structure according to the experimental example, and current values (I, A) for each case are measured.

As can be seen from FIG. 21, a clear polarization state inversion may be confirmed under a positive (+) voltage condition. Accordingly, it can be inferred that a position of copper ion (Cu+) in the ferroelectric layer (CIPS) is changed due to an external electric field applied to the ferroelectric structure, and thus the dipole arrangement is changed.

In addition, it can be confirmed that a rapid increase in the current intensity starts to occur at about +2 V. Therefore, it can be seen that a transition from a high resistance state to a low resistance state occurs due to polarization from about +2 V.

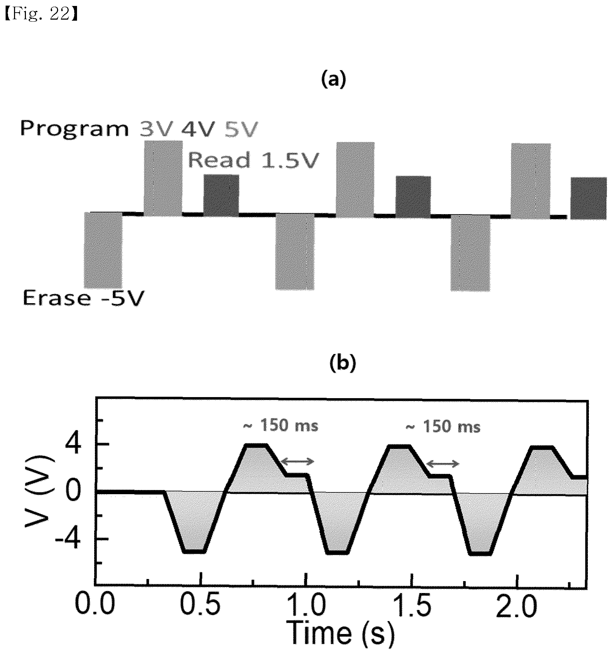

FIG. 22 is a view for explaining a voltage application process for obtaining a random current signal through the ferroelectric structure according to the experimental example of the present invention.

Referring to FIG. 22, it shows a process of applying an operating voltage Vprogram for forming a random polarization state in the ferroelectric structure according to the experimental example, a read voltage Vread for reading a current signal thereto, and then an erase voltage Verase for restoring the ferroelectric structure to an initial condition. Each of the voltages was applied in the form of a pulse, and a time interval between the pulse and the next pulse was all set to 150 ms. The repetitive erase voltage application and the operating voltage application are main sources of entropy for implementing a true random number generator, and for quantitative evaluation of a random current signal according to dipole polarization, a total of 784 repetitive cycles consisting of application of the operating voltage -> application of the read voltage -> acquisition of the current value -> application of the erase voltage were performed.

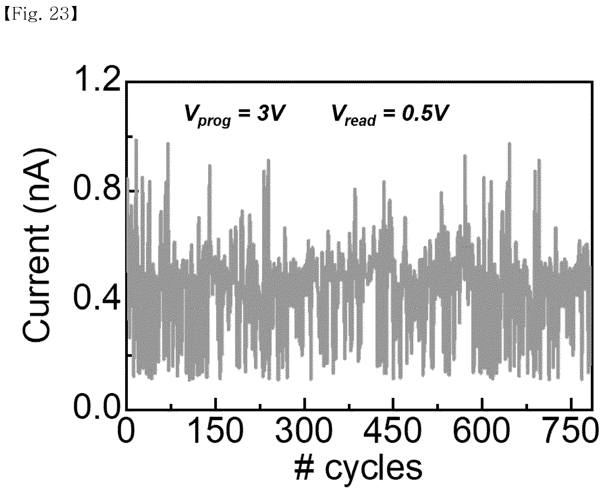

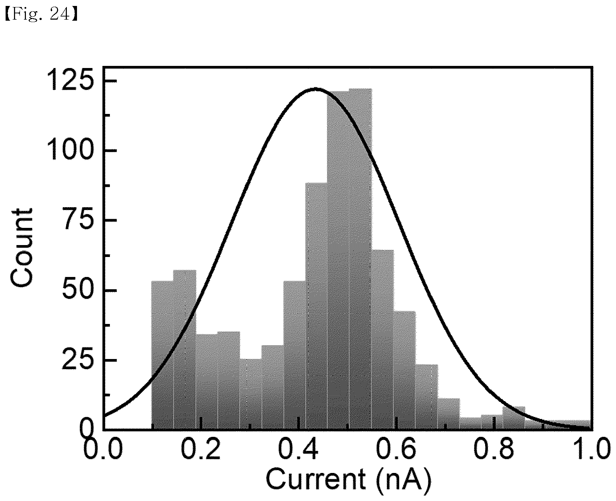

FIG. 23 is a view showing a current value measured in a state in which an operating voltage of 3 V and a read voltage of 0.5 V are applied for 784 cycles, and FIG. 24 is a view showing a current distribution histogram based on results of FIG. 23.

Referring to FIG. 23, it shows a change in a current value measured in a process of inputting a constant operating voltage ($V_{prog}$ = 3 V) and a constant read voltage ($V_{read}$ = 0.5 V) 784 times, and referring to FIG. 24, it shows a current distribution histogram approximated by a Gaussian function by classifying the current value (Current, nA) obtained from FIG. 23 by the number of occurrences (Count).

As can be seen from FIGS. 23 and 24, it can be confirmed that random current values are obtained in the process of inputting the constant operating voltage (3 V) and the constant read voltage (0.5 V) 784 times, and an average value of the obtained current values is 0.434 nA.

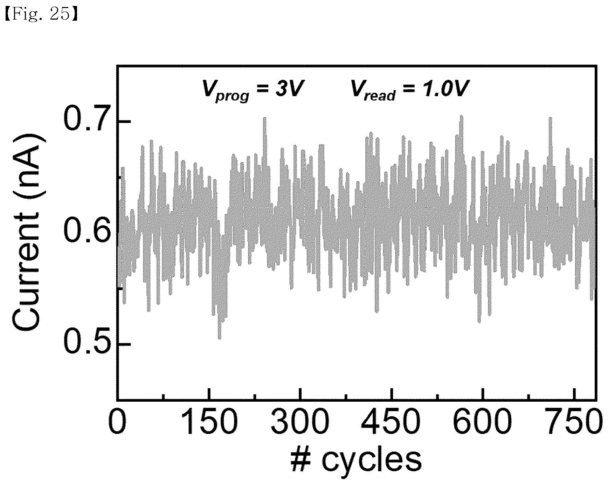

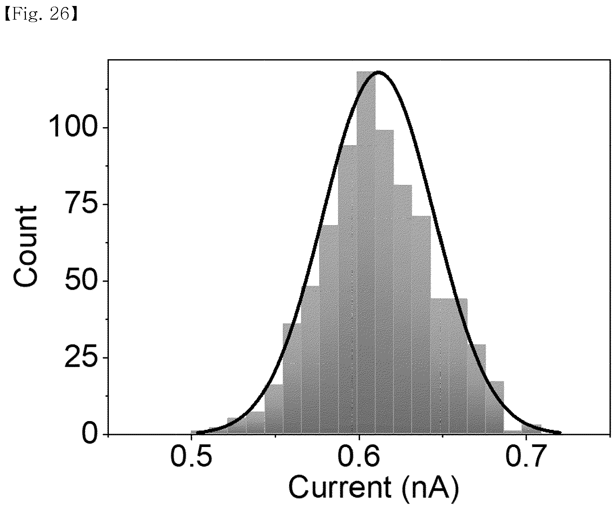

FIG. 25 is a view showing a current value measured in a state in which an operating voltage of 3 V and a read voltage of 1.0 V are applied for 784 cycles, and FIG. 26 is a view showing a current distribution histogram based on results of FIG. 25.

Referring to FIG. 25, it shows a change in a current value measured in a process of inputting a constant operating voltage ($V_{prog}$ = 3 V) and a constant read voltage ($V_{read}$ = 1.0 V) 784 times, and referring to FIG. 26, it shows a current distribution histogram approximated by a Gaussian function by classifying the current value (Current, nA) obtained from FIG. 25 by the number of occurrences (Count).

As can be seen from FIGS. 25 and 26, it can be confirmed that random current values are obtained in the process of inputting the constant operating voltage (3 V) and the constant read voltage (1.0 V) 784 times, and an average value of the obtained current values is 0.612 nA.

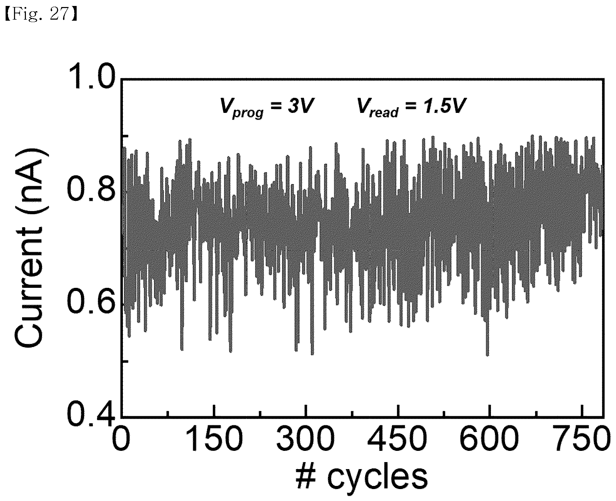

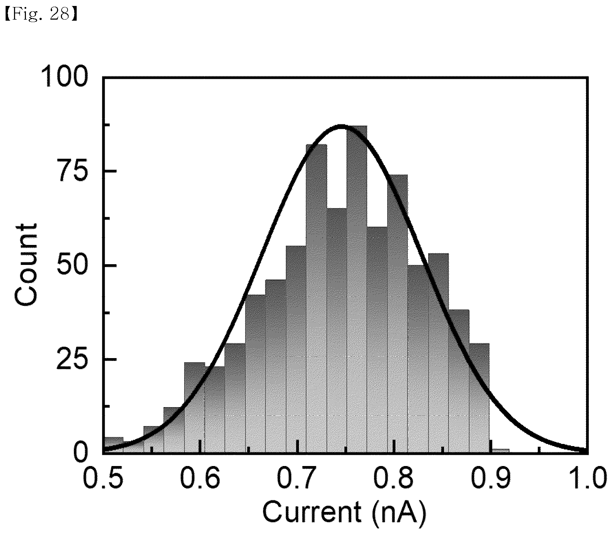

FIG. 27 is a view showing a current value measured in a state in which an operating voltage of 3 V and a read voltage of 1.5 V are applied for 784 cycles, and FIG. 28 is a view showing a current distribution histogram based on results of FIG. 27.

Referring to FIG. 27, it shows a change in a current value measured in a process of inputting a constant operating voltage ($V_{prog}$ = 3 V) and a constant read voltage ($V_{read}$ = 1.5 V) 784 times, and referring to FIG. 28, it shows a current distribution histogram approximated by a Gaussian function by classifying the current value (Current, nA) obtained from FIG. 27 by the number of occurrences (Count).

As can be seen from FIGS. 27 and 28, it can be confirmed that random current values are obtained in the process of inputting the constant operating voltage (3 V) and the constant read voltage (1.5 V) 784 times, and an average value of the obtained current values is 0.746 nA.

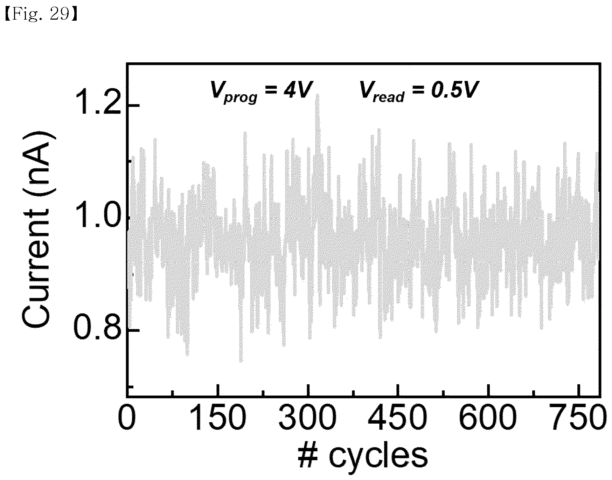

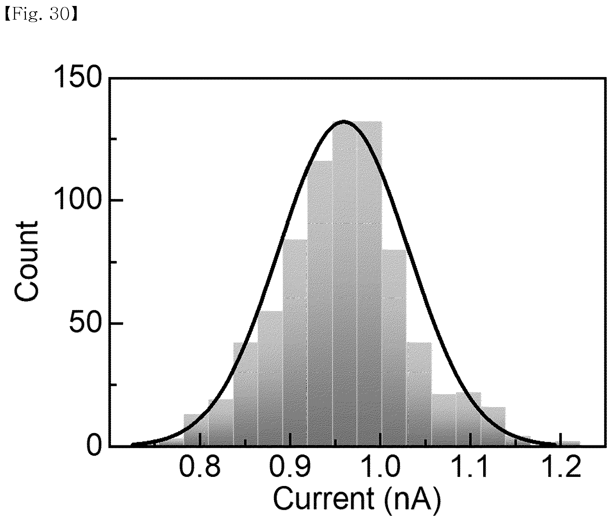

FIG. 29 is a view showing a current value measured in a state in which an operating voltage of 4 V and a read voltage of 0.5 V are applied for 784 cycles, and FIG. 30 is a view showing a current distribution histogram based on results of FIG. 29.

Referring to FIG. 29, it shows a change in a current value measured in a process of inputting a constant operating voltage ($V_{prog}$ = 4 V) and a constant read voltage ($V_{read}$ = 0.5 V) 784 times, and referring to FIG. 30, it shows a current distribution histogram approximated by a Gaussian function by classifying the current value (Current, nA) obtained from FIG. 29 by the number of occurrences (Count).

As can be seen from FIGS. 29 and 30, it can be confirmed that random current values are obtained in the process of inputting the constant operating voltage (4 V) and the constant read voltage (0.5 V) 784 times, and an average value of the obtained current values is 0.953 nA.

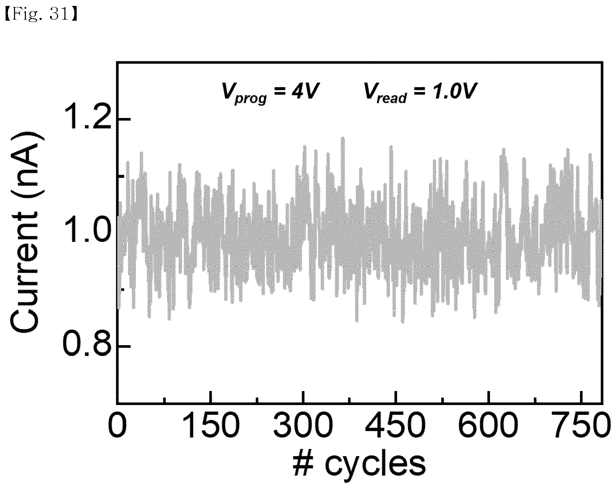

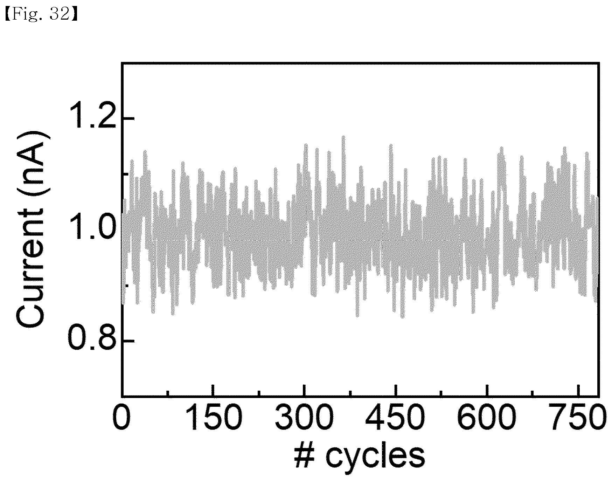

FIG. 31 is a view showing a current value measured in a state in which an operating voltage of 4 V and a read voltage of 1.0 V are applied for 784 cycles, and FIG. 32 is a view showing a current distribution histogram based on results of FIG. 31.

Referring to FIG. 31, it shows a change in a current value measured in a process of inputting a constant operating voltage ($V_{prog}$ = 4 V) and a constant read voltage ($V_{read}$ = 1.0 V) 784 times, and referring to FIG. 32, it shows a current distribution histogram approximated by a Gaussian function by classifying the current value (Current, nA) obtained from FIG. 31 by the number of occurrences (Count).

As can be seen from FIGS. 31 and 32, it can be confirmed that random current values are obtained in the process of inputting the constant operating voltage (4 V) and the constant read voltage (1.0 V) 784 times, and an average value of the obtained current values is 0.993 nA.

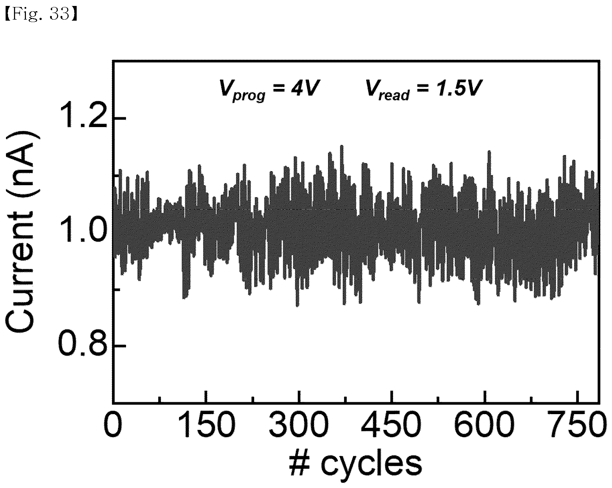

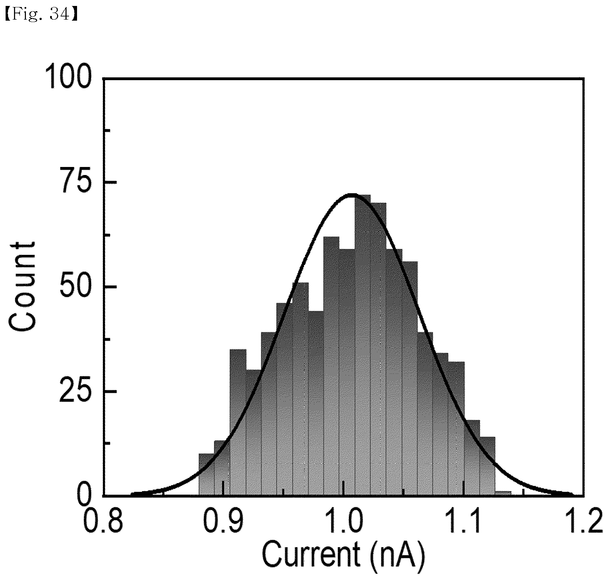

FIG. 33 is a view showing a current value measured in a state in which an operating voltage of 4 V and a read voltage of 1.5 V are applied for 784 cycles, and FIG. 34 is a view showing a current distribution histogram based on results of FIG. 33.

Referring to FIG. 33, it shows a change in a current value measured in a process of inputting a constant operating voltage ($V_{prog}$ = 4 V) and a constant read voltage ($V_{read}$ = 1.5 V) 784 times, and referring to FIG. 34, it shows a current distribution histogram approximated by a Gaussian function by classifying the current value (Current, nA) obtained from FIG. 33 by the number of occurrences (Count).

As can be seen from FIGS. 33 and 34, it can be confirmed that random current values are obtained in the process of inputting the constant operating voltage (4 V) and the constant read voltage (1.5 V) 784 times, and an average value of the obtained current values is 1.007 nA.

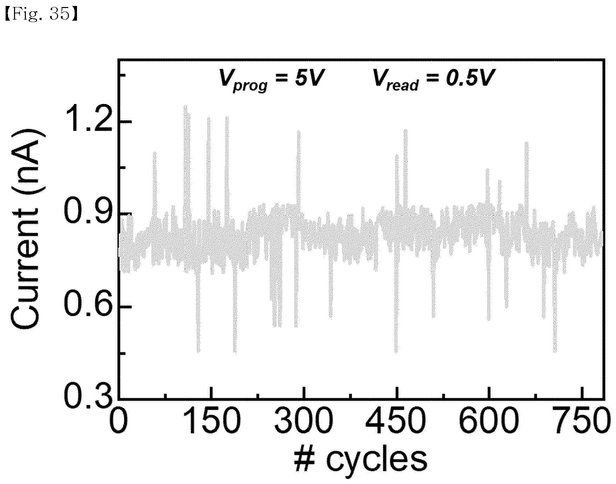

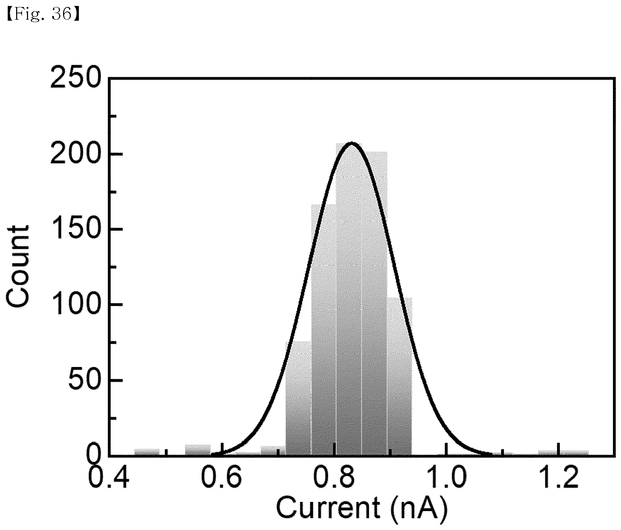

FIG. 35 is a view showing a current value measured in a state in which an operating voltage of 5 V and a read voltage of 0.5 V are applied for 784 cycles, and FIG. 36 is a view showing a current distribution histogram based on results of FIG. 35.

Referring to FIG. 35, it shows a change in a current value measured in a process of inputting a constant operating voltage ($V_{prog}$ = 5 V) and a constant read voltage ($V_{read}$ = 0.5 V) 784 times, and referring to FIG. 36, it shows a current distribution histogram approximated by a Gaussian function by classifying the current value (Current, nA) obtained from FIG. 35 by the number of occurrences (Count).

As can be seen from FIGS. 35 and 36, it can be confirmed that random current values are obtained in the process of inputting the constant operating voltage (5 V) and the constant read voltage (0.5 V) 784 times, and an average value of the obtained current values is 0.831 nA.

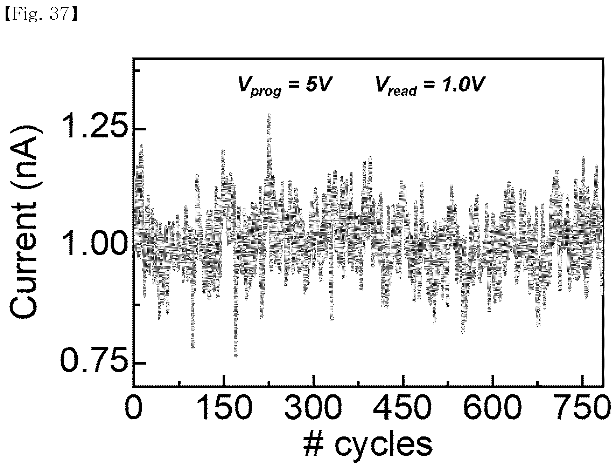

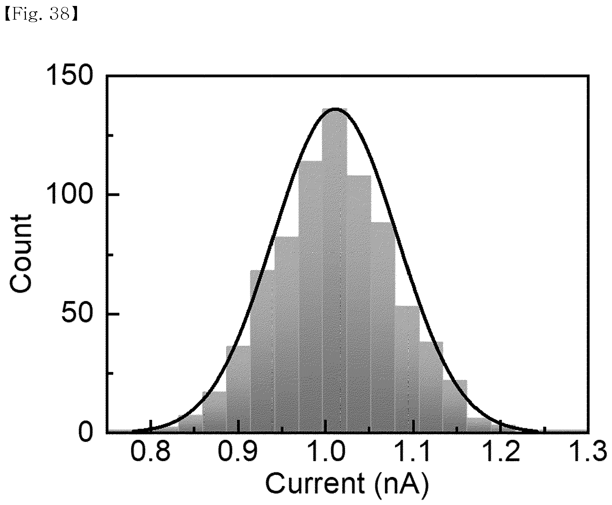

FIG. 37 is a view showing a current value measured in a state in which an operating voltage of 5 V and a read voltage of 1.0 V are applied for 784 cycles, and FIG. 38 is a view showing a current distribution histogram based on results of FIG. 37.

Referring to FIG. 37, it shows a change in a current value measured in a process of inputting a constant operating voltage ($V_{prog}$ = 5 V) and a constant read voltage ($V_{read}$ = 1.0 V) 784 times, and referring to FIG. 38, it shows a current distribution histogram approximated by a Gaussian function by classifying the current value (Current, nA) obtained from FIG. 37 by the number of occurrences (Count).

As can be seen from FIGS. 37 and 38, it can be confirmed that random current values are obtained in the process of inputting the constant operating voltage (5 V) and the constant read voltage (1.0 V) 784 times, and an average value of the obtained current values is 1.011 nA.

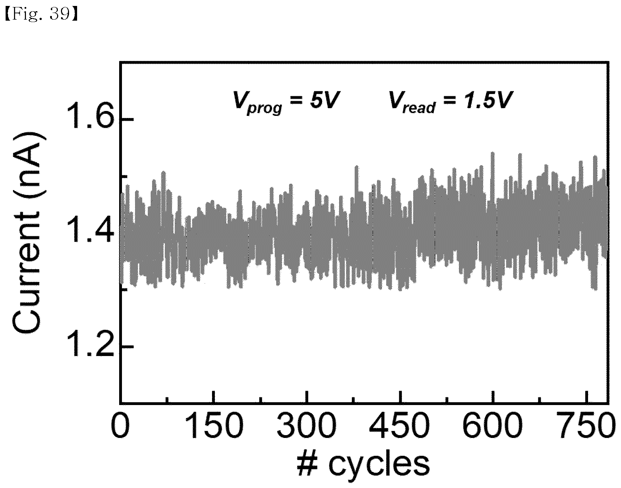

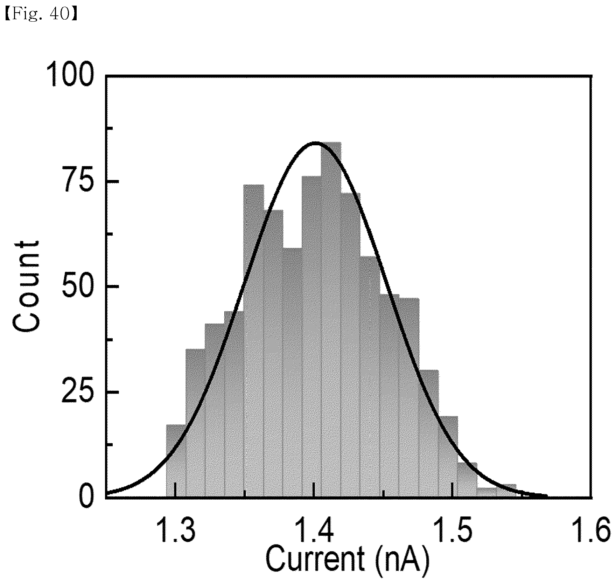

FIG. 39 is a view showing a current value measured in a state in which an operating voltage of 5 V and a read voltage of 1.5 V are applied for 784 cycles, and FIG. 40 is a view showing a current distribution histogram based on results of FIG. 39.

Referring to FIG. 39, it shows a change in a current value measured in a process of inputting a constant operating voltage ($V_{prog}$ = 5 V) and a constant read voltage ($V_{read}$ = 1.5 V) 784 times, and referring to FIG. 40, it shows a current distribution histogram approximated by a Gaussian function by classifying the current value (Current, nA) obtained from FIG. 39 by the number of occurrences (Count).

As can be seen from FIGS. 39 and 40, it can be confirmed that random current values are obtained in the process of inputting the constant operating voltage (5 V) and the constant read voltage (1.5 V) 784 times, and an average value of the obtained current values is 1.401 nA.

The average current values confirmed through FIGS. 23 to 40 are summarized through <Table 1> below.

[Table 1]

| Operating voltage value ($V_{prog}$) | Read voltage value ($V_{read}$) | Average current value (nA) |
|---|---|---|
| 3 V | 0.5 V | 0.434 |
| 3 V | 1.0 V | 0.612 |
| 3 V | 1.5 V | 0.746 |
| 4 V | 0.5 V | 0.959 |
| 4 V | 1.0 V | 0.993 |
| 4 V | 1.5 V | 1.007 |

(continued)

| Operating voltage value ($V_{prog}$) | Read voltage value ($V_{read}$) | Average current value (nA) |
|---|---|---|
| 5 V | 0.5 V | 0.831 |
| 5 V | 1.0 V | 1.011 |
| 5 V | 1.5 V | 1.401 |

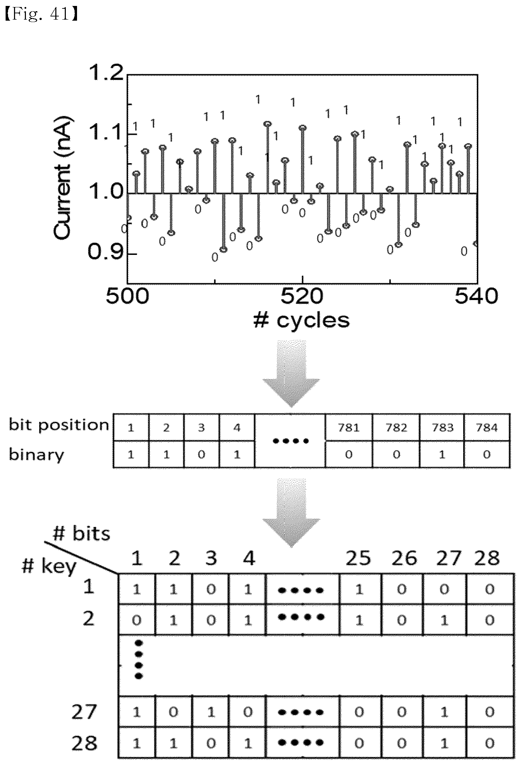

FIG. 41 is a view for explaining binarization and key classification processes for a random current value through the ferroelectric structure according to the experimental example of the present invention.

Referring to FIG. 41, it shows a binarization process and key classification process for the current value measured in a state in which a constant operating voltage and a constant read voltage are applied for 784 cycles.

More specifically, current values were measured in the state in which a constant operating voltage and a constant read voltage are applied for 784 cycles, and an average current value for the current values measured for 784 cycles was calculated. In addition, based on the calculated average current value, a current value greater than or equal to the average current value was binarized to a state of "1", and a current value less than the average current value was binarized to a state of "0". Through the above-described process, 784 bits were generated, and 28 bits of the generated 784 bits were configured as one key and classified as a total of 28 keys.

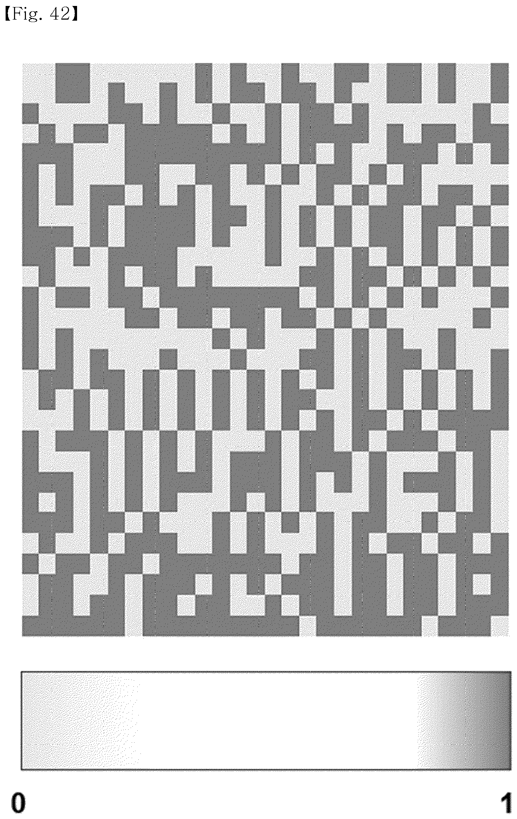

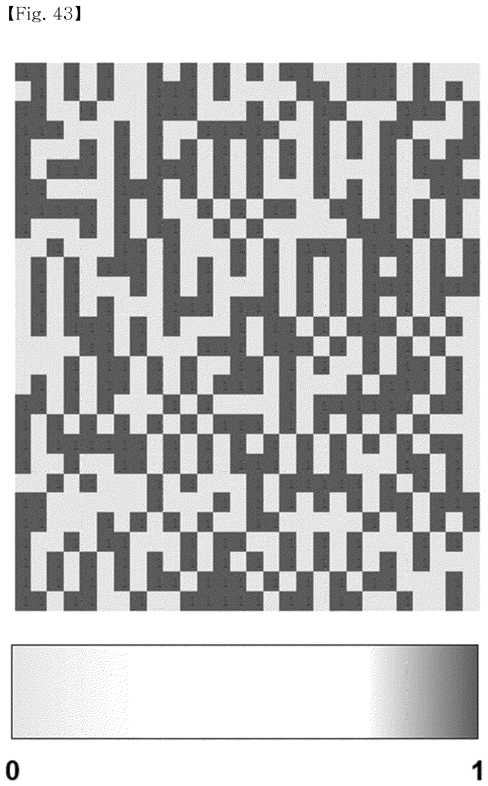

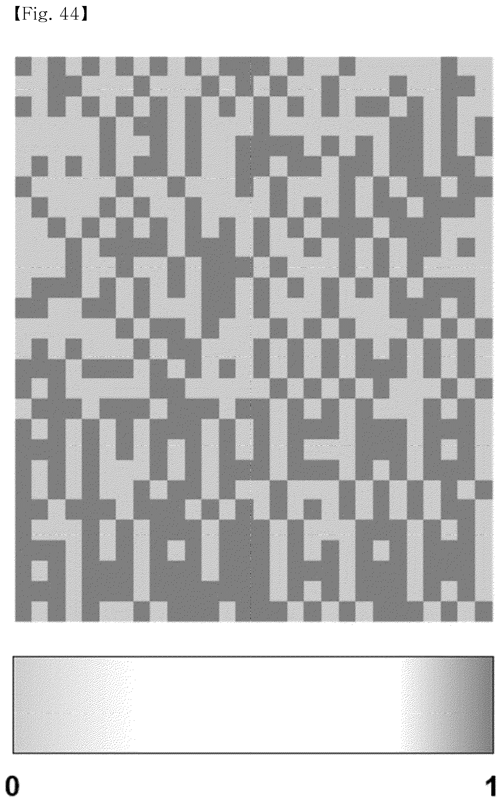

FIG. 42 is a view showing binarization and key classification results for a case in which an operating voltage of 3 V is applied as an image, FIG. 43 is a view showing binarization and key classification results for a case in which an operating voltage of 4 V is applied as an image, and FIG. 44 is a view showing binarization and key classification results for a case in which an operating voltage of 5 V is applied as an image.

Referring to FIGS. 42 to 44, binarization and key classification are performed according to the method described with reference to FIG. 41, and the binarization and key classification are represented by color images of 28 x 28 pixels. As can be seen from FIGS. 42 to 44, mutually different random images are represented according to an operating voltage being applied.

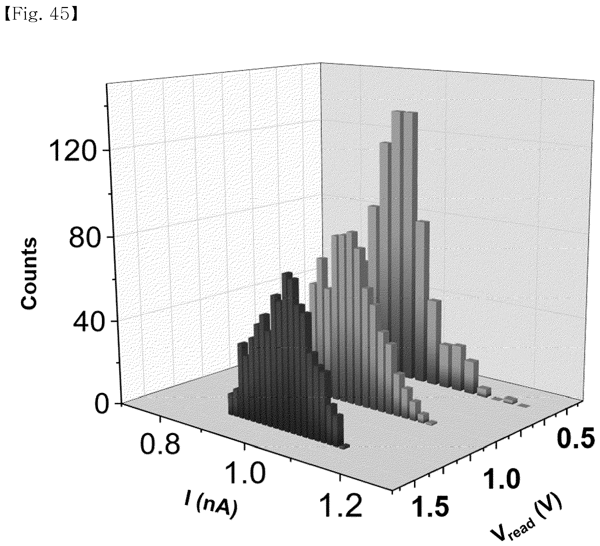

FIG. 45 is a view showing a histogram of current values obtained from mutually different read voltages.

Referring to FIG. 45, it shows a histogram for the number of occurrences (Counts) according to current values (I, nA) obtained when read voltages ($V_{read}$, V) of 0.5 V, 1.0 V, and 1.5 V are applied after an operating voltage of 4 V is applied. As can be seen from FIG. 45, fluctuation of the histogram depends greatly on the condition of the read voltage, and the stochasticity in which the current signal may be observed under the condition of the read voltage that is lower than the coercive voltage may be confirmed.

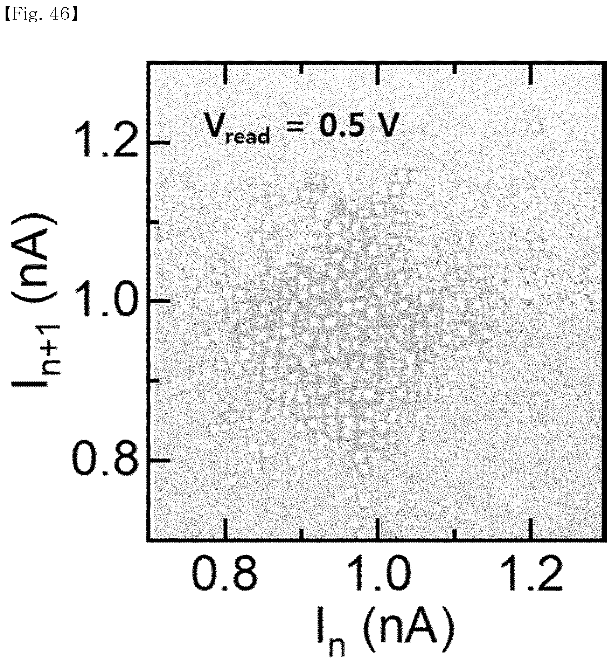

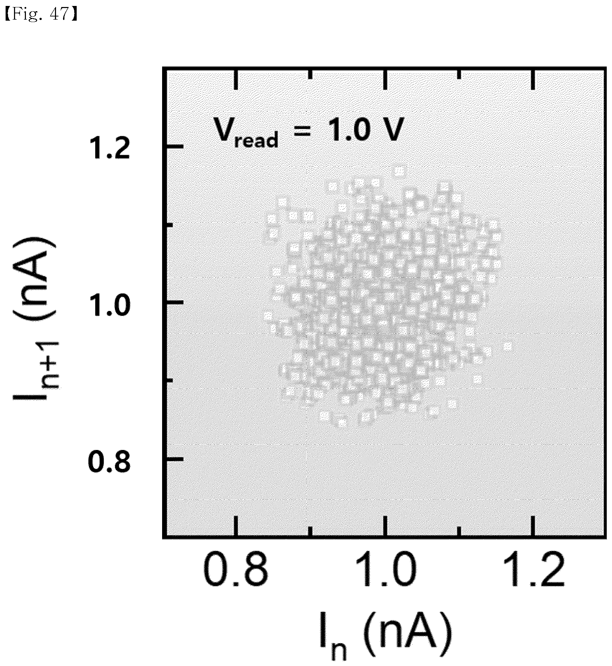

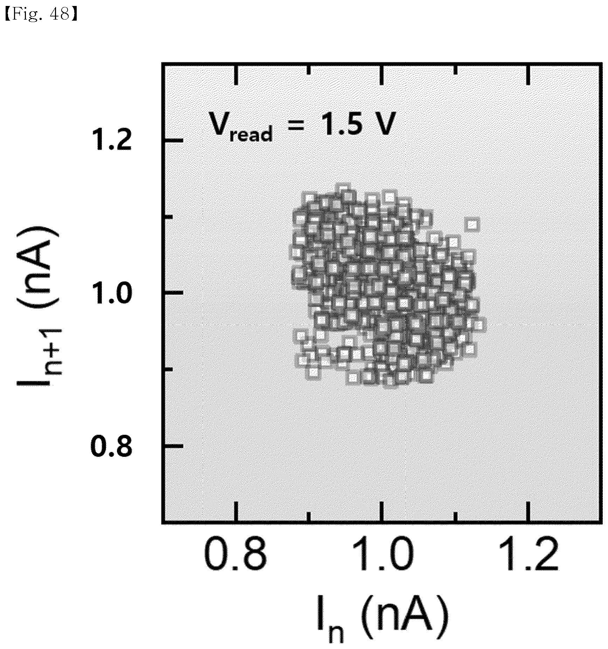

FIG. 46 is a view showing a parallax plot of current fluctuation for a read voltage of 0.5 V, FIG. 47 is a view showing a parallax plot of current fluctuation for a read voltage of 1.0 V, and FIG. 48 is a view showing a parallax plot of current fluctuation for a read voltage of 1.5 V.

Referring to FIGS. 46 to 48, it shows a degree of current fluctuation (time lag plot, TLP) for read voltages of 0.5 V, 1.0 V, and 1.5 V. As can be seen from FIGS. 46 to 48, an independent correlation between intensity ($I_n$, nA) of a nth current signal and intensity ($I_{n+1}$, nA) of a $(n+1)$[th] current signal may be confirmed.

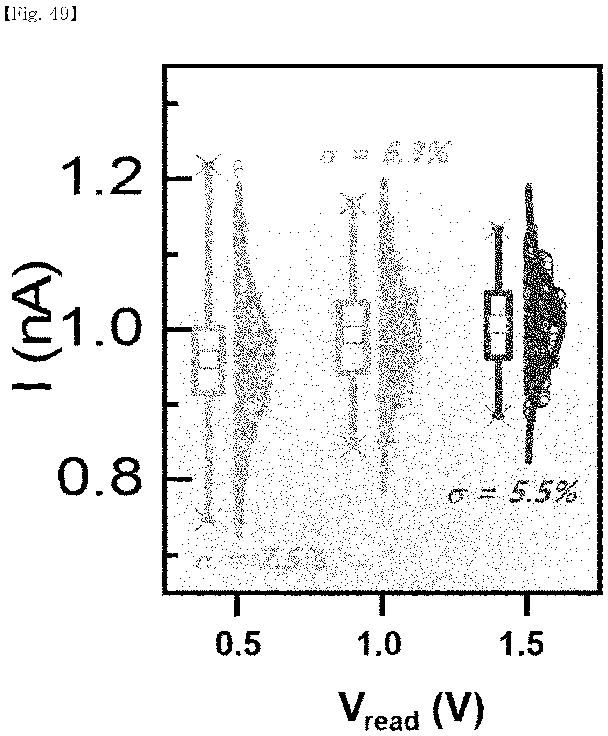

FIG. 49 is a view showing a magnitude of current fluctuation according to a read voltage intensity.

Referring to FIG. 49, it shows a magnitude (I, nA) of current fluctuation for read voltages ($V_{read}$, V) of 0.5 V, 1.0 V, and 1.5 V. Variability or uniformity may act as an important parameter that identifies ideal operating conditions.

As can be seen from FIG. 49, when the operating voltage is 4 V and the read voltage is 0.5 V, variability ($\sigma$) is calculated as 7.5%, when the operating voltage is 4 V and the read voltage is 1.0 V, the variability ($\sigma$) is calculated as 6.3%, and when the operating voltage is 4 V and the read voltage is 1.5 V, the variability ($\sigma$) is calculated as 5.5%.

Experimental Example 4: Ideal Operating Voltage And Read Voltage Derivation for Ferroelectric Structure to Have Ideal Random Number Generation Performance

A uniformity value was derived through the following Equation 1, and an entropy value was derived through Equation 2. In a case of the ideal random number generator, since the expression possibility in a state of 0 and the expression possibility in a state of 1 are equal to 50%, the uniformity value is 0.5 and the entropy value is 1. Further, in describing Experimental Example 4, binarization and key classification were performed as described with reference to FIG. 41.

<Equation 1>

$$U = N(state1)/[N(state1) + N(state0)]$$

(U: Uniformity, N(state1): Expression possibility in state of 1, N(state0): Expression possibility in state of 0

<Equation 2>

$$E = -[\mathrm{p}\log_2 p + (1 - p)\log_2(1 - p)]$$

(E: Entropy, p: Expression possibility in state of 1, 1-p: Expression possibility in state of 0)

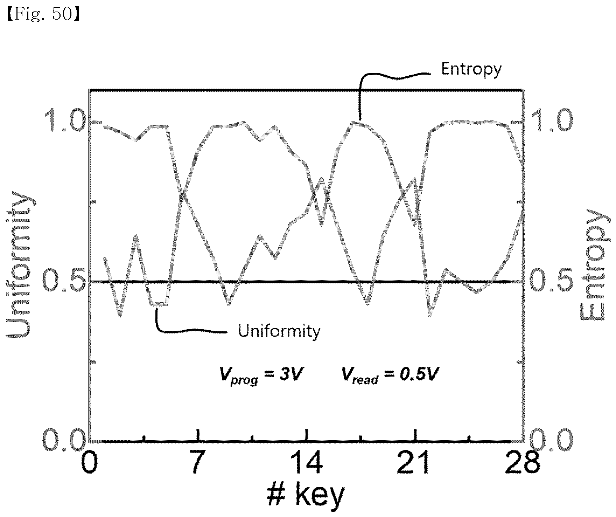

FIG. 50 is a view showing a uniformity value and an entropy value derived in a state in which an operating voltage of 3 V and a read voltage of 0.5 V are applied.

Referring to FIG. 50, it shows a uniformity value and an entropy value which are measured for each of 28 keys classified in a state where an operating voltage of 3 V and a read voltage of 0.5 V are applied.

As can be seen from FIG. 50, when the operating voltage of 3 V and the read voltage of 0.5 V are applied, the uniformity value shows a large difference from 0.5 and the entropy value shows a large difference from 1. That is, it can be seen that the operating voltage of 3 V and the read voltage of 0.5 V are not ideal operating voltage and read voltage.

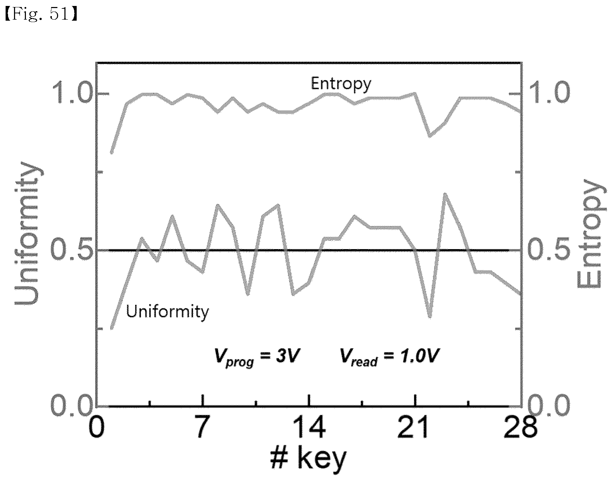

FIG. 51 is a view showing a uniformity value and an entropy value derived in a state in which an operating voltage of 3 V and a read voltage of 1.0 V are applied.

Referring to FIG. 51, it shows a uniformity value and an entropy value which are measured for each of 28 keys classified in a state where an operating voltage of 3 V and a read voltage of 1.0 V are applied.

As can be seen from FIG. 51, when the operating voltage of 3 V and the read voltage of 1.0 V are applied, the uniformity value shows a large difference from 0.5 and the entropy value shows a small difference from 1. That is, it can be seen that the operating voltage of 3 V and the read voltage of 1.0 V are not ideal operating voltage and read voltage.

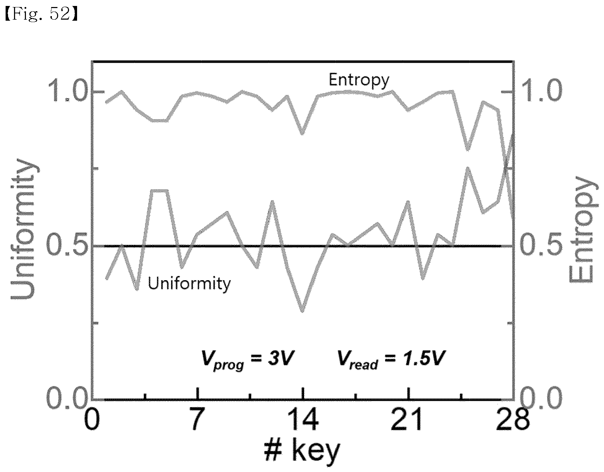

FIG. 52 is a view showing a uniformity value and an entropy value derived in a state in which an operating voltage of 3 V and a read voltage of 1.5 V are applied.

Referring to FIG. 52, it shows a uniformity value and an entropy value which are measured for each of 28 keys classified in a state where an operating voltage of 3 V and a read voltage of 1.5 V are applied.

As can be seen from FIG. 52, when the operating voltage of 3 V and the read voltage of 1.5 V are applied, the uniformity value shows a large difference from 0.5 and the entropy value shows a large difference from 1. That is, it can be seen that the operating voltage of 3 V and the read voltage of 1.5 V are not ideal operating voltage and read voltage.

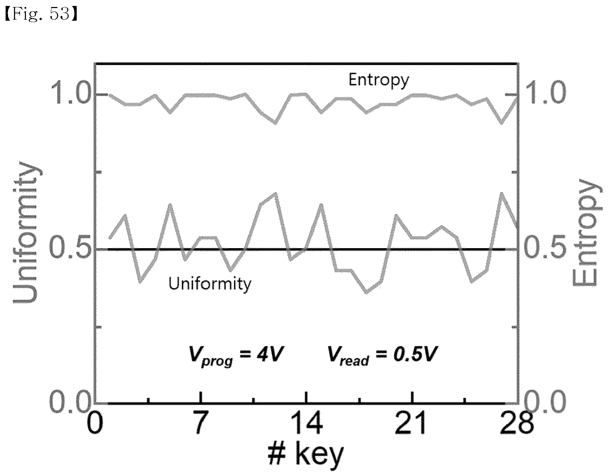

FIG. 53 is a view showing a uniformity value and an entropy value derived in a state in which an operating voltage of 4 V and a read voltage of 0.5 V are applied.

Referring to FIG. 53, it shows a uniformity value and an entropy value which are measured for each of 28 keys classified in a state where an operating voltage of 4 V and a read voltage of 0.5 V are applied.

As can be seen from FIG. 53, when the operating voltage of 4 V and the read voltage of 0.5 V are applied, the uniformity value shows a large difference from 0.5 and the entropy value shows a small difference from 1. That is, it can be seen that the operating voltage of 4 V and the read voltage of 0.5 V are not ideal operating voltage and read voltage.

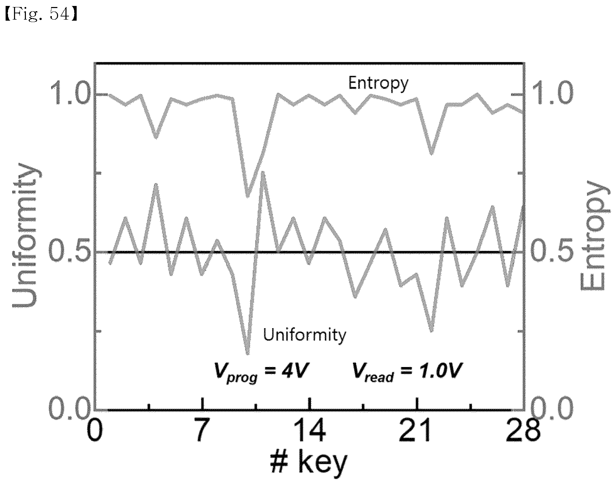

FIG. 54 is a view showing a uniformity value and an entropy value derived in a state in which an operating voltage of 4 V and a read voltage of 1.0 V are applied.

Referring to FIG. 54, it shows a uniformity value and an entropy value which are measured for each of 28 keys classified in a state where an operating voltage of 4 V and a read voltage of 1.0 V are applied.

As can be seen from FIG. 54, when the operating voltage of 4 V and the read voltage of 1.0 V are applied, the uniformity value shows a large difference from 0.5 and the entropy value shows a small difference from 1. That is, it can be seen that the operating voltage of 4 V and the read voltage of 1.0 V are not ideal operating voltage and read voltage.

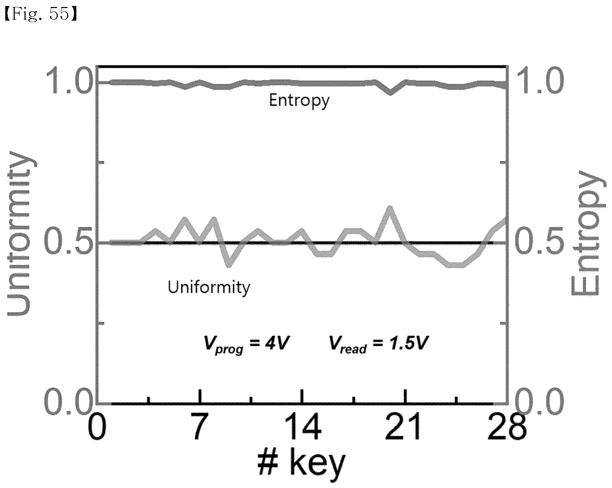

FIG. 55 is a view showing a uniformity value and an entropy value derived in a state in which an operating voltage of 4 V and a read voltage of 1.5 V are applied.

Referring to FIG. 55, it shows a uniformity value and an entropy value which are measured for each of 28 keys classified in a state where an operating voltage of 4 V and a read voltage of 1.5 V are applied.

As can be seen from FIG. 55, when the operating voltage of 4 V and the read voltage of 1.5 V are applied, uniformity values of all keys (0 to 28 keys) are close to 0.5 and entropy values of all keys (0 to 28 keys) are close to 1. That is, it can be seen that the operating voltage of 4 V and the read voltage of 1.5 V are ideal operating voltage and read voltage.

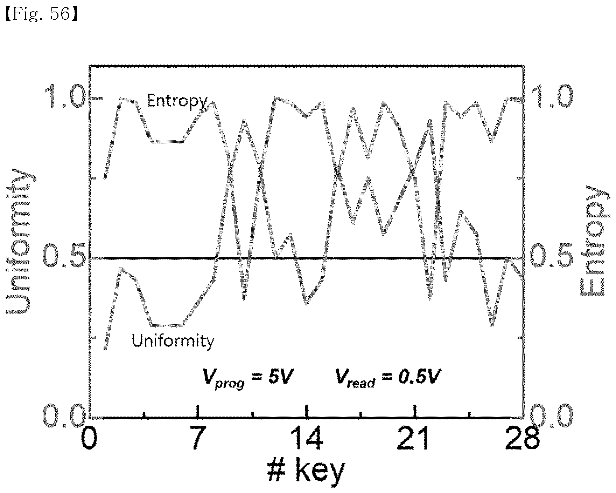

FIG. 56 is a view showing a uniformity value and an entropy value derived in a state in which an operating voltage of 5 V and a read voltage of 0.5 V are applied.

Referring to FIG. 56, it shows a uniformity value and an entropy value which are measured for each of 28 keys classified in a state where an operating voltage of 5 V and a read voltage of 0.5 V are applied.

As can be seen from FIG. 56, when the operating voltage of 5 V and the read voltage of 0.5 V are applied, the uniformity value shows a large difference from 0.5 and the entropy value shows a large difference from 1. That is, it can be seen that the operating voltage of 5 V and the read voltage of 0.5 V are not ideal operating voltage and read voltage.

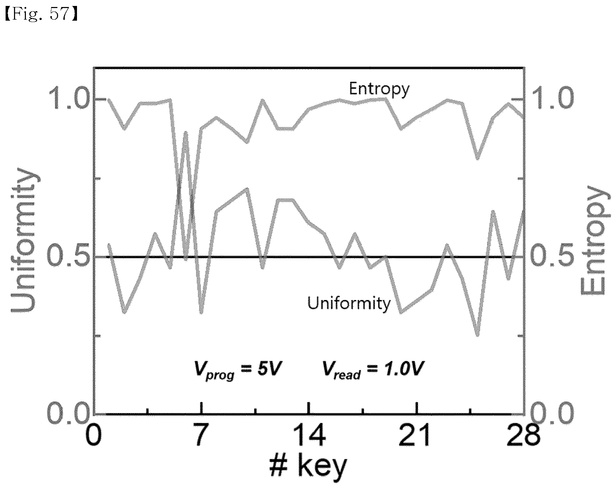

FIG. 57 is a view showing a uniformity value and an entropy value derived in a state in which an operating voltage of 5 V and a read voltage of 1.0 V are applied.

Referring to FIG. 57, it shows a uniformity value and an entropy value which are measured for each of 28 keys classified in a state where an operating voltage of 5 V and a read voltage of 1.0 V are applied.

As can be seen from FIG. 57, when the operating voltage of 5 V and the read voltage of 1.0 V are applied, the uniformity value shows a large difference from 0.5 and the entropy value shows a large difference from 1. That is, it can be seen that the operating voltage of 5 V and the read voltage of 1.0 V are not ideal operating voltage and read voltage.

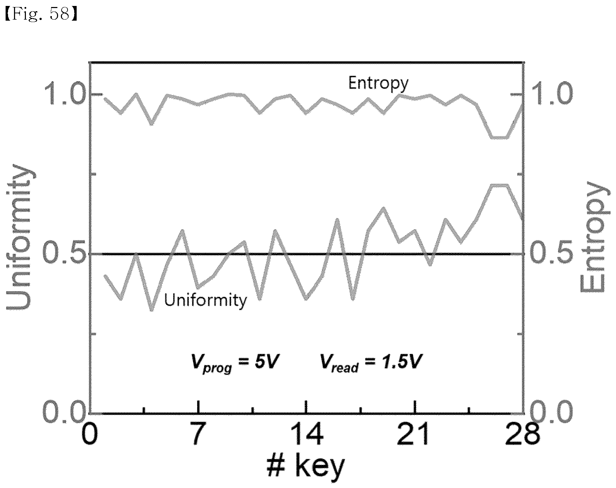

FIG. 58 is a view showing a uniformity value and an entropy value derived in a state in which an operating voltage of 5 V and a read voltage of 1.5 V are applied.

Referring to FIG. 58, it shows a uniformity value and an entropy value which are measured for each of 28 keys classified in a state where an operating voltage of 5 V and a read voltage of 1.5 V are applied.

As can be seen from FIG. 58, when the operating voltage of 5 V and the read voltage of 1.5 V are applied, the uniformity value shows a large difference from 0.5 and the entropy value shows a small difference from 1. That is, it can be seen that the operating voltage of 5 V and the read voltage of 1.5 V are not ideal operating voltage and read voltage.

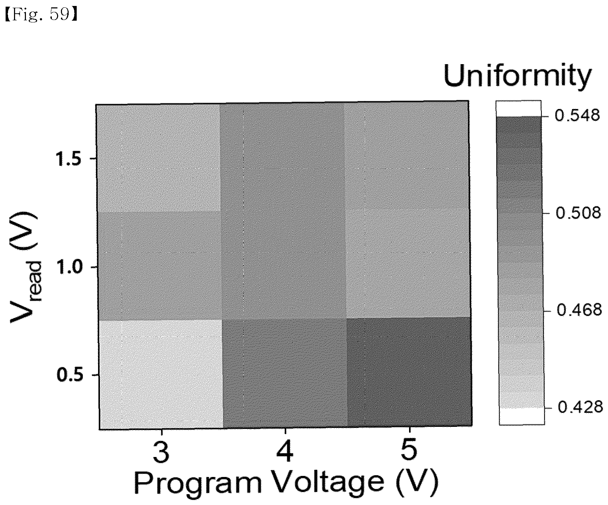

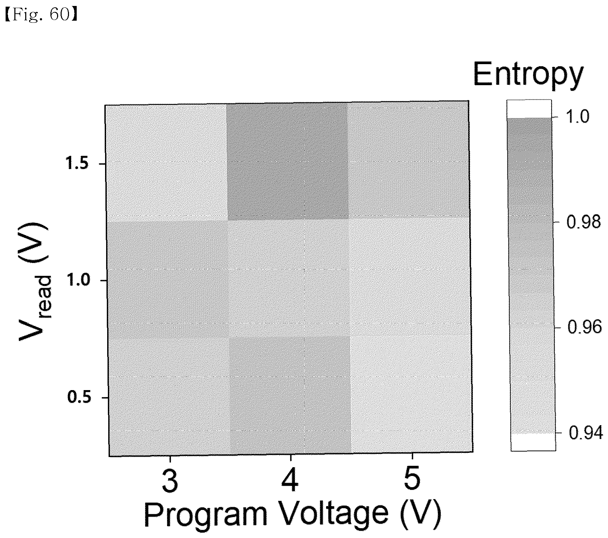

FIG. 59 is a view visualizing uniformity values at mutually different operating voltages and read voltages, and FIG. 60 is a view visualizing entropy values at mutually different operating voltages and read voltages.

Referring to FIGS. 59 and 60, an average uniformity value (average value of uniformity values measured from 28 keys) and an average entropy value (average value of entropy values measured from 28 keys) at different operating voltages (3 V, 4 V, and 5 V) and different read voltages (0.5 V, 1.0 V, and 1.5 V) are represented by a color map image.

As can be seen from FIG. 59, the average uniformity value measured at the operating voltage of 4 V and the read voltage of 1.5 V is close to 0.5, and as can be seen from FIG. 60, the average entropy value measured at the operating voltage of 4 V and the read voltage of 1.5 V is close to 1.

As a result, it can be confirmed once again that the ferroelectric structure according to the experimental example has an ideal operating voltage of 4 V and a read voltage of 1.5 V to have an ideal random number generation performance.

Experimental Example 5: Calculation of Additional Parameters for Randomness Verification of Ferroelectric Structure

Based on the ideal operating voltage of 4 V and the read voltage of 1.5 V, which were derived through Experimental Example 4, a Hamming distance (HDintra) and a correlation coefficient (CCintra), by which the randomness of an output result of the ferroelectric structure according to the experimental example may be determined, were calculated.

The Hamming distance (HDintra) was used to evaluate randomness between binarized keys, which was defined as the number of bit substitutions required to convert one key into another key, and was used to compare keys generated in the same apparatus.

In order to form a key that is considered to be cryptographically safe, the hamming distance is necessarily 50% or greater. For example, the Hamming distance of a key composed of 28 bits is necessarily 14. On the other hand, it is known that a key having a Hamming distance value that is too low or too high may be relatively and easily decrypted by a Brute Force Testing, which is a method of hacking.

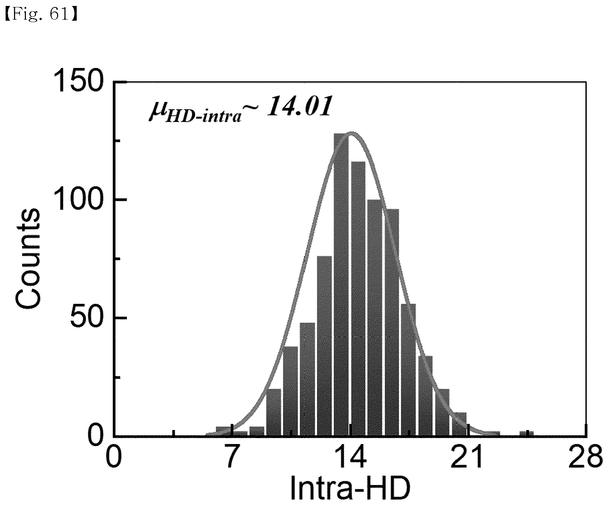

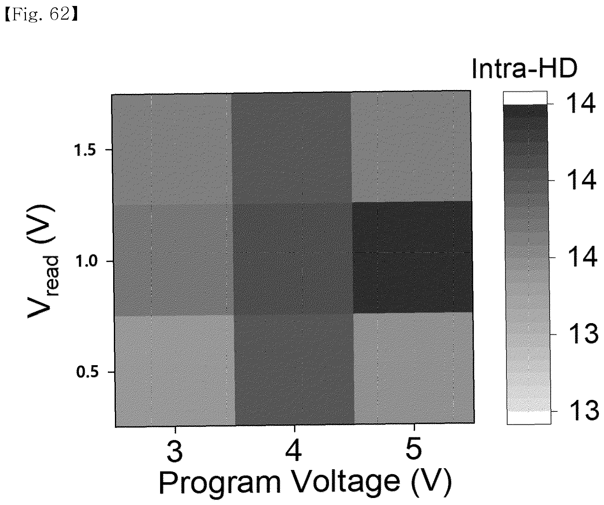

FIG. 61 is a view showing a Hamming distance histogram of the ferroelectric structure according to the experimental example of the present invention, and FIG. 62 is a view visualizing average Hamming distance values at mutually different operating voltages and read voltages.

Referring to FIG. 61, it shows 378 Hamming distance histogram images from among keys composed of 28 bits measured under the condition of an operating voltage of 4 V and a read voltage of 1.5 V. As can be seen from FIG. 61, an average Hamming distance value of the ferroelectric structure according to the experimental example is 14.01 that is close to an ideal value. Accordingly, it can be seen that the ferroelectric structure according to the experimental example has excellent encryption ability.

Referring to FIG. 62, it shows a color map image for an average Hamming distance value (Intra-HD) under the condition of mutually different operating voltages and read voltages. As can be seen from FIG. 62, the average Hamming distance value is close to 14 under the condition of an operating voltage of 4 V and a read voltage of 1.5 V.

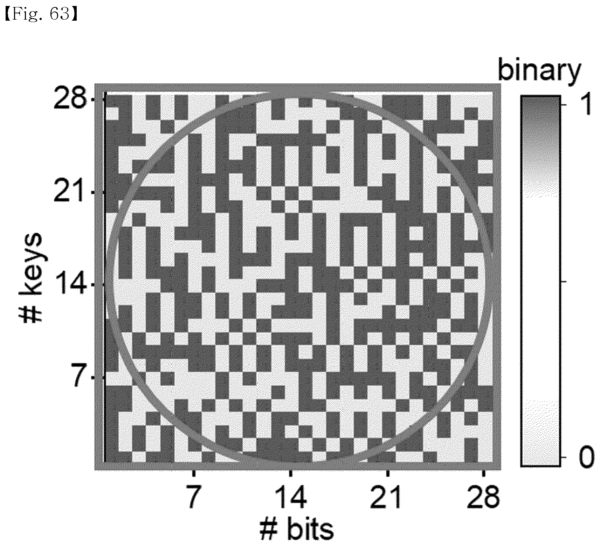

FIG. 63 is a view showing an image in which a $\pi$ value is estimated using a Monte-Carlo simulation.

Referring to FIG. 63, the $\pi$ value was estimated using the Monte-Carlo simulation. More specifically, the above-described method uses the fact that a value obtained by dividing an area of a circle having a radius of r by an area of a square having a length of 2r is $\pi/4$. In order to implement the method, as shown in FIG. 63, a binarized color map image composed of 28 x 28 pixels was implemented using the binarized key obtained from the ferroelectric structure according to the experimental example. In this case, a dark pixel indicates a bit "1", and a bright pixel indicates a bit "0". Next, in order to estimate the $\pi$ value, a ratio of the number of bright pixels inside the largest circle and the number of bright pixels inside the square was calculated. As a result of the calculation, it was confirmed that the ferroelectric structure according to the experimental example has a $\pi$ value of 3.1 close to an actual value.

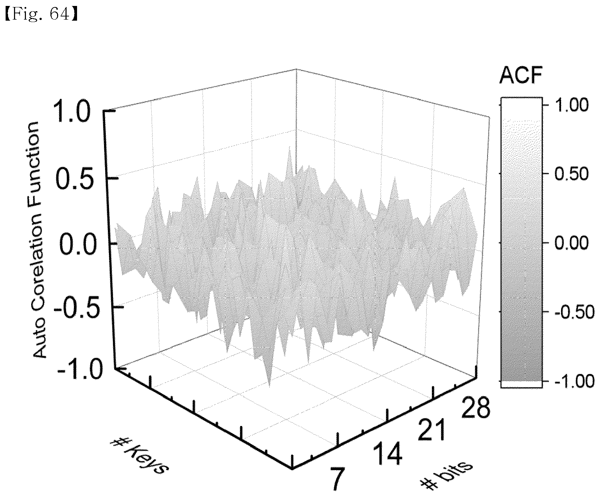

FIG. 64 is a view showing an autocorrelation image for each different key of the ferroelectric structure according to the experimental example of the present invention.

Referring to FIG. 64, it shows autocorrelation as a function of a bit delay of each of 28 keys having a length of 28 bits obtained under the condition of an operating voltage of 4 V and a read voltage of 1.5 V.

As can be seen from FIG. 64, a high spike is not confirmed, and thus it can be seen that there is substantially no periodicity in the key. That is, it can be seen that a bit stream generated through the ferroelectric structure according to the experimental example is essentially a random point.

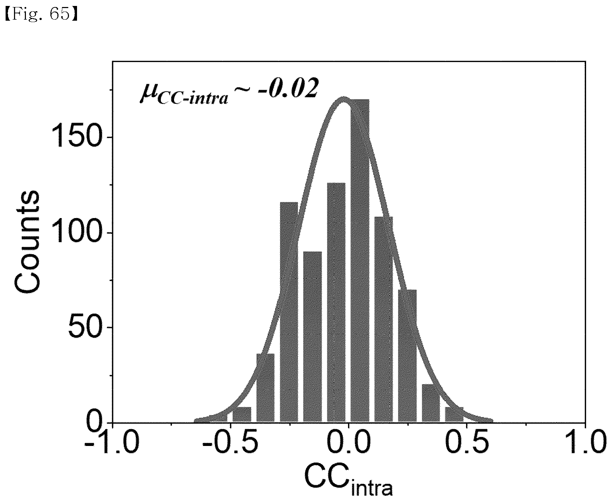

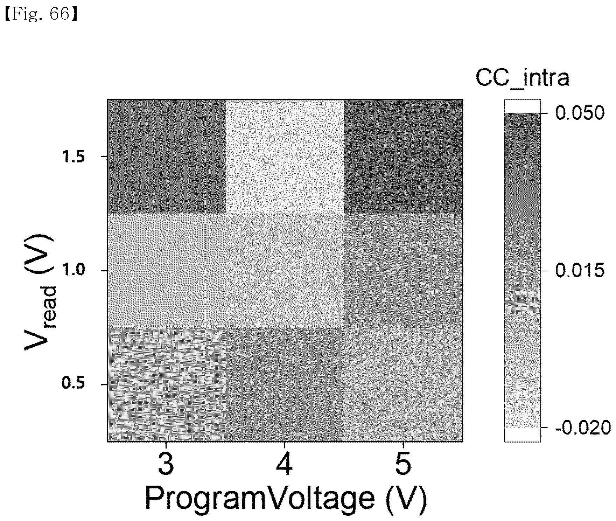

FIG. 65 is a view showing a correlation coefficient histogram of the ferroelectric structure according to the experimental example of the present invention, and FIG. 66 is a view visualizing average correlation coefficient values at mutually different operating voltages and read voltages.

Referring to FIGS. 65 and 66, a correlation coefficient (CCintra) verification was performed to determine a degree of correlation by verifying periodicity between different bits. An autocorrelation function (ACF) is located in the [-1, 1] section, which means that the value of -1 shows semi-correlation, the value of 1 shows correlation, and the value of 0 shows no correlation with each other. In addition, results shown in FIGS. 65 and 66 show the autocorrelation of each 28-bit key measured under the condition of an operating voltage of 4 V and a read voltage of 1.5 V.

As can be seen from FIG. 65, it can be seen that the correlation coefficient value is about -0.02. Accordingly, it can be seen that the ferroelectric structure according to the experimental example has excellent random number expression ability as a true random number generator (TRNG). Moreover, as can be seen from FIG. 62, the average correlation coefficient value is close to -0.02 under the condition of an operating voltage of 4 V and a read voltage of 1.5 V.

Experimental Example 6: Evaluation of International Standard Encryption Performance of Ferroelectric Structure

A standard statistical test package developed by the National Institute of Standards and Technology (NIST sp 800-22 rev. 1a) was used to perform a randomness evaluation with a true random number generator (TRNG) of the ferroelectric structure according to the experimental example.

Experimental Example 6 described above is to determine whether a ferroelectric structure-based random number generator according to the experimental example having a metal-CIPS-metal structure exhibits a performance suitable for random number generation for security purposes. To this end, random current data of a total of 15,680 bits were extracted, null hypothesis for randomness was evaluated, and the data was evaluated using a test protocol that returns a P-value of 99% confidence level. In this case, a bit is considered as a true random only when the P-value is greater than 0.001.

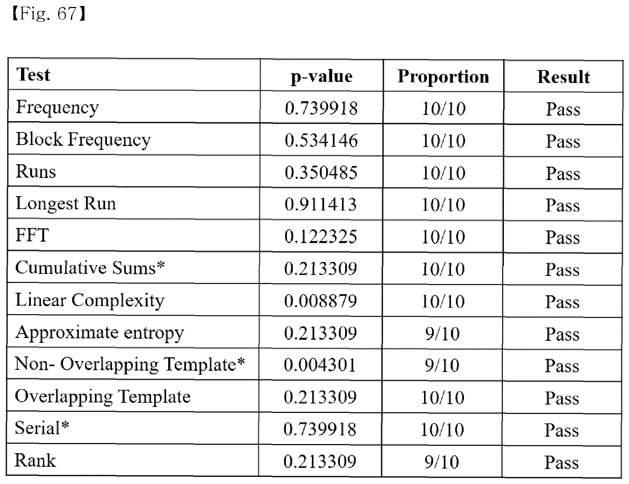

FIG. 67 is a view for explaining results of evaluating international standard encryption performance according to Experimental Example 6.

As shown in FIG. 67, it can be seen that all the NIST tests pass successfully without the post-processing step. Thus, it can be seen that the ferroelectric structure-based true random number generator according to the experimental example has high suitability in the encryption field.

Experimental Example 7: Verification of Random Number Generation Parameters between Different Ferroelectric Structures

A physical unclonable function is a basic requirement of the true random number generator. Specifically, this is to prevent anyone from reverse designing the random number generator because a random number result generated from one random number generator may not be replicated by another random number generator.

In Experimental Example 7, in order to evaluate the physical unclonable function of the ferroelectric structure-based true random number generator according to the experimental example, 10 ferroelectric structures according to the experimental example were prepared, and 28 bit keys were generated for each of the ferroelectric structures under an operating voltage of 4 V and a read voltage of 1.5 V.

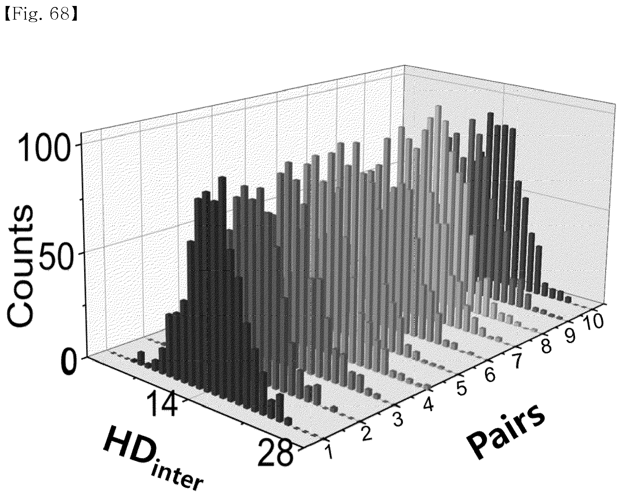

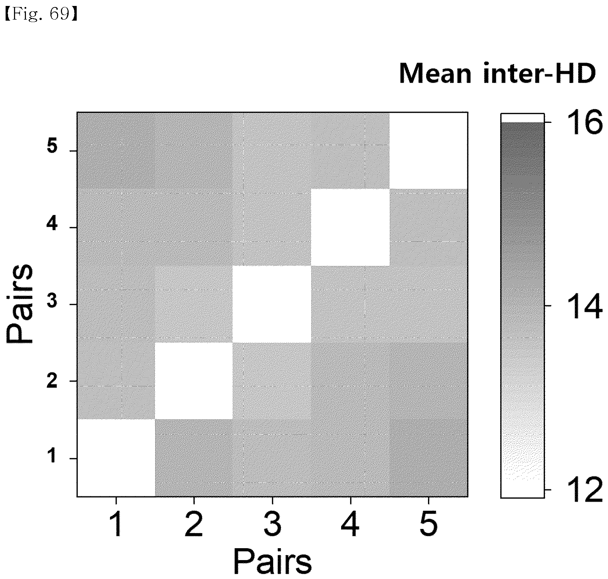

FIG. 68 is a view showing a Hamming distance histogram between 28 keys obtained from 10 mutually different pairs of ferroelectric structures, and FIG. 69 is a view visualizing average Hamming distance values at 10 mutually different pairs of ferroelectric structures.

Referring to FIG. 68, it shows a Hamming distance (HDineter) histogram between 28 keys obtained from 10 mutually different pairs (Pairs) of ferroelectric structures, and referring to FIG. 69, it shows color map image of average Hamming distance ($\mu$HDinter) values at 10 mutually different pairs (Pairs) of ferroelectric structures. The inter shown in FIG. 68 means a distance between key pairs generated using different structures. As can be seen from FIGS. 68 and 69, it can be seen that the average Hamming distance value is close to an ideal value of 14, which is a result of proving that random number results generated in different structures are unique.

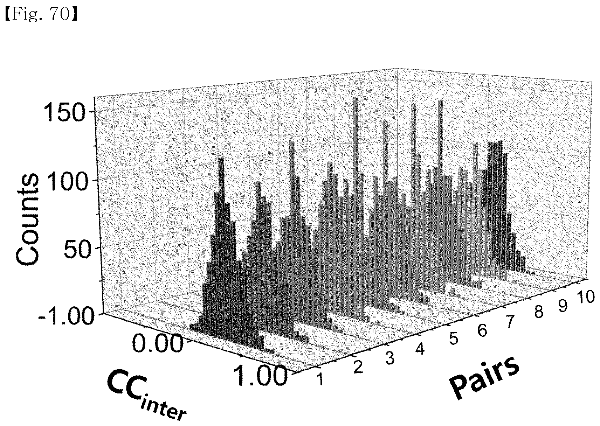

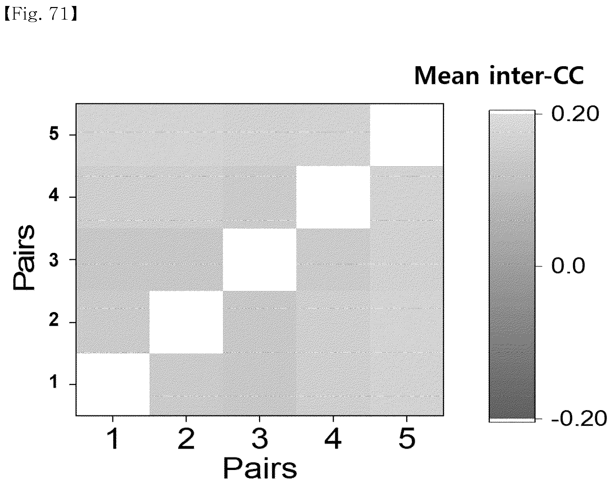

FIG. 70 is a view showing a Hamming distance histogram between 28 keys obtained from 10 mutually different pairs of ferroelectric structures, and FIG. 71 is a view visualizing average correlation coefficient values at 10 mutually different pairs of ferroelectric structures.

Referring to FIG. 70, it shows a correlation coefficient (CCinter) histogram between 28 keys obtained from 10 mutually different pairs (Pairs) of ferroelectric structures, and referring to FIG. 71, it shows color map image of average correlation coefficient ($\mu$CCinter) values at 10 mutually different pairs (Pairs) of ferroelectric structures. As can be seen from FIGS. 70 and 71, it can be seen that the average correlation coefficient value is close to an ideal value of 0, which is a result of proving that there is no random number results generated in different structures.

While the present invention has been described in connection with the embodiments, it is not to be limited thereto but will be defined by the appended claims. In addition, it is to be understood that those skilled in the art can substitute, change, or modify the embodiments in various forms without departing from the scope and spirit of the present invention.

## Claims

1. A method for manufacturing a ferroelectric structure, the method comprising:

   preparing a substrate;
   forming a lower electrode on the substrate;
   forming a ferroelectric layer, which includes a two-dimensional ferroelectric material, on the lower electrode; and
   forming an upper electrode on the ferroelectric layer.

2. The method for manufacturing a ferroelectric structure of claim 1, wherein when the same voltage is applied multiple times, current values having mutually different intensities are generated for each applied voltage.

3. The method for manufacturing a ferroelectric structure of claim 1, wherein when a voltage is applied, polarization occurs in the ferroelectric layer.

4. The method for manufacturing a ferroelectric structure of claim 1, wherein when the voltage is applied, out-of-plane (OOP) polarization occurs in the ferroelectric layer.

5. The method for manufacturing a ferroelectric structure of claim 1, wherein the ferroelectric material includes a compound of mutually different elements, and
   when the voltage is applied, a position of any one element ion of the mutually different elements included in the ferroelectric material is changed in the ferroelectric layer.

6. The method for manufacturing a ferroelectric structure of claim 1, wherein a crystal structure of the ferroelectric layer is changed due to the element ion that changes the position in the ferroelectric layer.

7. The method for manufacturing a ferroelectric structure of claim 1, wherein the ferroelectric layer is changed from a symmetric crystal structure to an anti-symmetric crystal structure.

8. A method for operating a ferroelectric structure, the method comprising:

   preparing a ferroelectric layer that includes a substrate, a lower electrode disposed on the substrate, a ferroelectric layer disposed on the lower electrode and including a two-dimensional ferroelectric material, and an upper electrode disposed on the ferroelectric layer;
   applying an operating voltage to the ferroelectric structure such that polarization occurs in the ferroelectric layer;
   applying a read voltage to the ferroelectric structure to obtain a current value reflecting a polarization state of the ferroelectric layer; and
   applying an erase voltage to the ferroelectric structure such that the ferroelectric layer is restored to a state before the polarization.

9. The method of claim 8, wherein the applying of the operating voltage, the obtaining of the current value, and the applying of the erase voltage are sequentially repeated while repeatedly applying the same operating voltage.

【Fig. 1】

```
        ┌─────────┐
        │  Start  │
        └─────────┘
             │
             ▼
┌───────────────────────────────┐
│      Preparing substrate      │──── S110
└───────────────────────────────┘
             │
             ▼
┌───────────────────────────────┐
│ Forming lower electrode on    │──── S120
│          substrate            │
└───────────────────────────────┘
             │
             ▼
┌───────────────────────────────┐
│ Forming ferroelectric including│
│ two-dimensional ferroelectric │──── S130
│ material on lower electrode   │
└───────────────────────────────┘
             │
             ▼
┌───────────────────────────────┐
│ Forming upper electrode on    │──── S140
│      ferroelectric layer      │
└───────────────────────────────┘
             │
             ▼
        ┌─────────┐
        │   End   │
        └─────────┘
```

【Fig. 2】

S110

|             | 120 |
|             |     | 100
|             | 110 |

【Fig. 3】

S120

|                           | 200 |
|                           | 120 | 100
|                           | 110 |

【Fig. 4】

S130

300

200

120
110
}100

【Fig. 5】

S140

【Fig. 6】

```
                    ┌──────────┐
                    │  Start   │
                    └────┬─────┘
                         │
                         ▼
┌─────────────────────────────────────────────────┐
│             Preparing substrate                  │──── S10
└─────────────────────────┬───────────────────────┘
                          │
                          ▼
┌─────────────────────────────────────────────────┐
│ Applying operating voltage to ferroelectric      │
│ structure such that polarization occurs in       │──── S20
│ ferroelectric layer                              │
└─────────────────────────┬───────────────────────┘
                          │
                          ▼
┌─────────────────────────────────────────────────┐
│ Applying read voltage to ferroelectric           │
│ structure to obtain current value reflecting     │──── S30
│ polarization state of ferroelectric layer        │
└─────────────────────────┬───────────────────────┘
                          │
                          ▼
┌─────────────────────────────────────────────────┐
│ Applying erase voltage to ferroelectric          │
│ structure such that ferroelectric layer is       │──── S40
│ restored to state before polarization            │
└─────────────────────────┬───────────────────────┘
                          │
                          ▼
                    ┌──────────┐
                    │   End    │
                    └──────────┘
```

【Fig. 7】

【Fig. 8】

【Fig. 9】

【Fig. 10】

【Fig. 11】

【Fig. 12】

Tip

CIPS

Au

【Fig. 13】

【Fig. 14】

【Fig. 15】

【Fig. 16】

【Fig. 17】

【Fig. 18】

【Fig. 19】

【Fig. 20】

【Fig. 21】

【Fig. 22】

(a)

(b)

【Fig. 23】

【Fig. 24】

【Fig. 25】

【Fig. 26】

【Fig. 27】

【Fig. 28】

【Fig. 29】

【Fig. 30】

【Fig. 31】

【Fig. 32】

【Fig. 33】

【Fig. 34】

【Fig. 35】

【Fig. 36】

【Fig. 37】

【Fig. 38】

【Fig. 39】

【Fig. 40】

【Fig. 41】

【Fig. 42】

0            1

【Fig. 43】

0                                                                    1

【Fig. 44】

0        1

【Fig. 45】

【Fig. 46】

【Fig. 47】

【Fig. 48】

【Fig. 49】

【Fig. 50】

【Fig. 51】

【Fig. 52】

【Fig. 53】

【Fig. 54】

【Fig. 55】

【Fig. 56】

【Fig. 57】

【Fig. 58】

【Fig. 59】

【Fig. 60】

【Fig. 61】

【Fig. 62】

【Fig. 63】

【Fig. 64】

【Fig. 65】

【Fig. 66】

【Fig. 67】

| Test | p-value | Proportion | Result |
|---|---|---|---|
| Frequency | 0.739918 | 10/10 | Pass |
| Block Frequency | 0.534146 | 10/10 | Pass |
| Runs | 0.350485 | 10/10 | Pass |
| Longest Run | 0.911413 | 10/10 | Pass |
| FFT | 0.122325 | 10/10 | Pass |
| Cumulative Sums* | 0.213309 | 10/10 | Pass |
| Linear Complexity | 0.008879 | 10/10 | Pass |
| Approximate entropy | 0.213309 | 9/10 | Pass |
| Non- Overlapping Template* | 0.004301 | 9/10 | Pass |
| Overlapping Template | 0.213309 | 10/10 | Pass |
| Serial* | 0.739918 | 10/10 | Pass |
| Rank | 0.213309 | 9/10 | Pass |

【Fig. 68】

【Fig. 69】

【Fig. 70】

【Fig. 71】

Europäisches
Patentamt

European
Patent Office

Office européen
des brevets

# EUROPEAN SEARCH REPORT

**Application Number**

EP 24 18 0802

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YU-CHIEH CHIEN ET AL: "Attack Resilient True Random Number Generators Using Ferroelectric-Enhanced Stochasticity in 2D Transistor", SMALL, WILEY, HOBOKEN, USA, vol. 19, no. 38, 17 May 2023 (2023-05-17), page n/a, XP072500708, ISSN: 1613-6810, DOI: 10.1002/SMLL.202302842 | 1,3-9 | INV. G11C11/22 G11C7/10 G06F7/58 |
| A | * paragraph [0002]; figure 1 * | 2 | |
| X | CN 115 394 920 A (JIAXING RESEARCH INSTITUTE OF ZHEJIANG UNIV; UNIV ZHEJIANG) 25 November 2022 (2022-11-25) | 1,3-9 | |
| A | * paragraph [0048] - paragraph [0071]; figure 1 * | 2 | |
| X | CHEN LI ET AL: "Ferroelectric memory based on two-dimensional materials for neuromorphic computing", NEUROMORPHIC COMPUTING AND ENGINEERING, vol. 2, no. 2, 1 June 2022 (2022-06-01), page 022001, XP093206945, ISSN: 2634-4386, DOI: 10.1088/2634-4386/ac57cb | 1,3-9 | |
| A | * paragraph [0004]; figures 2-3 * | 2 | |
| A | LEI YIN ET AL: "Emerging 2D Memory Devices for In-Memory Computing", ADVANCED MATERIALS, VCH PUBLISHERS, DE, vol. 33, no. 29, 8 June 2021 (2021-06-08), page n/a, XP071876594, ISSN: 0935-9648, DOI: 10.1002/ADMA.202007081 * paragraph [0002]; figures 3-4 * | 1-9 | |

**TECHNICAL FIELDS SEARCHED (IPC)**

G11C
H03K
G06F
H01L
H10B

The present search report has been drawn up for all claims

| Place of search | Date of completion of the search | Examiner |
|---|---|---|
| The Hague | 18 November 2024 | Lecoutre, Renaud |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 0802

This annex lists the patent family members relating to the patent documents cited in the above-mentioned European search report.
The members are as contained in the European Patent Office EDP file on
The European Patent Office is in no way liable for these particulars which are merely given for the purpose of information.

18-11-2024

| Patent document cited in search report | Publication date | Patent family member(s) | Publication date |
|---|---|---|---|
| CN 115394920 A | 25-11-2022 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Z. WEI ; Y. KATOH ; S. OGASAHARA ; Y. YOSHIMOTO ; K. KAWAI ; Y. IKEDA ; K. ERIGUCHI ; K. OHMORI ; S. YONEDA**. True random number generator using current difference based on a fractional stochastic model in 40-nm embedded ReR_AM. *2016 IEEE International Electron Devices Meeting (IEDM)*, 2016

- **BO LIU ; JING MA ; HAN HSIANG TAI ; DHARMENDRA VERMA ; MAMINA SAHOO ; YING-FENG CHANG ; HANYUAN LIANG ; SHIWEI FENG ; LAIN-JONG LI ; TUO-HUNG HOU**. Memristive True Random Number Generator with Intrinsic Two-Dimensional Physical Unclonable Function. *ACS Appl. Electron. Mater.*, 2023, vol. 5 (2), 714-720